# EUROPEAN PATENT APPLICATION

(11) **EP 4 550 987 A1**
(43) Date of publication of application: **07.05.2025**
(21) Application number: 24209314.4
(22) Date of filing: 28.10.2024
(51) Int. Cl.: H10K 50/19, H10K 59/122, H10K 59/124, H10K 59/38, H10K 59/80, H10K 50/852, H10K 50/818

(54) **DISPLAY DEVICE, WEARABLE ELECTRONIC DEVICE, AND METHOD OF MANUFACTURING DISPLAY DEVICE**

(30) Priority: 06.11.2023 KR 20230151686
(71) Applicant: Samsung Display Co., Ltd., Yongin-si, Gyeonggi-Do 17113 (KR)
(72) Inventor: YOU, Chun Gi, 17113 Yongin-si (KR)
(74) Representative: Marks & Clerk LLP

(57) **Abstract**

A display device includes: a first sub-pixel, a second sub-pixel, and a third sub-pixel, wherein each of the first sub-pixel, the second sub-pixel, and the third sub-pixel includes: a reflective electrode on a base layer; a planarization layer on the reflective electrode and providing a planar upper surface; an anode electrode on the planarization layer; an emission structure on the anode electrode; and a cathode electrode on the emission structure, wherein the first sub-pixel further includes a first buffer pattern between the base layer and the reflective electrode, and wherein in the third sub-pixel, the reflective electrode is directly on the base layer.

## Description

### BACKGROUND

### 1. Field

Aspects of some embodiments of the present disclosure relate to a display device, a wearable electronic device, and a method of fabricating the display device.

### 2. Description of Related Art

Organic light emitting diodes (OLEDs) are active emission display elements that not only feature a large viewing angle and excellent contrast but also can operate at a relatively low voltage. The OLEDs have advantages of being relatively lightweight, and thin, and having relatively fast response time characteristics.

The above information disclosed in this Background section is only for enhancement of understanding of the background and therefore the information discussed in this Background section does not necessarily constitute prior art.

### SUMMARY

Aspects of some embodiments of the present disclosure relate to a display device having relatively improved optical characteristics, a wearable electronic device, and a method of fabricating the display device.

Embodiments according to the present disclosure are not limited to the above-stated characteristics, and those skilled in the art will clearly understand other not mentioned characteristics from the accompanying claims, and their equivalents.

Aspects of some embodiments of the present disclosure include a display device, including a first sub-pixel, a second sub-pixel, and a third sub-pixel. According to some embodiments, each of the first sub-pixel, the second sub-pixel, and the third sub-pixel includes: a reflective electrode on a base layer; a planarization layer on the reflective electrode and configured to provide a planar upper surface; an anode electrode on the planarization layer; an emission structure on the anode electrode; and a cathode electrode on the emission structure. According to some embodiments, the first sub-pixel further includes a first buffer pattern between the base layer and the reflective electrode. According to some embodiments, in the third sub-pixel, the reflective electrode is directly on the base layer.

According to some embodiments, an average distance between the anode electrode and the reflective electrode in the first sub-pixel may be less than an average distance between the anode electrode and the reflective electrode in the third sub-pixel.

According to some embodiments, the first sub-pixel may further include a second buffer pattern between the first buffer pattern and the reflective electrode. According to some embodiments, the second sub-pixel may further include the first buffer pattern between the base layer and the reflective electrode. According to some embodiments, an average distance between the anode electrode and the reflective electrode in the second sub-pixel may be less than an average distance between the anode electrode and the reflective electrode in the third sub-pixel and greater than an average distance between the anode electrode and the reflective electrode in the first sub-pixel.

According to some embodiments, a thickness of the anode electrode in the first sub-pixel, a thickness of the anode electrode in the second sub-pixel, and a thickness of the anode electrode in the third sub-pixel may be identical to each other.

According to some embodiments, the first buffer pattern may include conductive material. According to some embodiments, the second buffer pattern may include insulating material.

According to some embodiments, a thickness of the first buffer pattern may be substantially identical to a thickness of the second buffer pattern.

According to some embodiments, an average thickness of the planarization layer in the second sub-pixel may be approximately 1.4 times to approximately 1.7 times an average thickness of the planarization layer in the first sub-pixel. According to some embodiments, an average thickness of the planarization layer in the third sub-pixel may be approximately 1.9 times to approximately 2.4 times an average thickness of the planarization layer in the first sub-pixel.

According to some embodiments, the emission structure may include: a first emission layer arranged in common in the first sub-pixel, the second sub-pixel, and the third sub-pixels, and configured to emit light in a first color; and a second emission layer on the first emission layer and configured to emit light in a second color.

According to some embodiments, the emission structure may further include a third emission layer on the second emission layer and configured to emit light in a third color.

According to some embodiments, in the second sub-pixel, the reflective electrode may be directly on the base layer.

According to some embodiments, the anode electrode may cover the reflective electrode and contact a side surface of the reflective electrode.

According to some embodiments, the display device may further include: a pixel defining layer on the base layer between the first to the third sub-pixels; and a protrusion pattern on the pixel defining layer and having a width increasing in an upward direction.

According to some embodiments, trenches may be formed to partially penetrate the planarization layer between the first to the third sub-pixels. The trenches may be separated from each other.

According to some embodiments, each of the first to the third sub-pixels may further include a color filter on the cathode electrode.

Aspects of some embodiments of the present disclosure include a wearable electronic device including: a display panel configured to emit light; and at least one lens on the display panel. According to some embodiments, the display panel includes a first sub-pixel, a second sub-pixel, and a third sub-pixel. According to some embodiments, each of the first sub-pixel, the second sub-pixel, and the third sub-pixel includes: a reflective electrode on a base layer; a planarization layer on the reflective electrode and configured to provide a planar upper surface; an anode electrode on the planarization layer; an emission structure on the anode electrode; and a cathode electrode on the emission structure. According to some embodiments, the first sub-pixel further includes a first buffer pattern between the base layer and the reflective electrode. In the third sub-pixel, the reflective electrode is directly on the base layer.

According to some embodiments, an average distance between the anode electrode and the reflective electrode in the first sub-pixel may be less than an average distance between the anode electrode and the reflective electrode in the third sub-pixel.

According to some embodiments, the first sub-pixel may further include a second buffer pattern between the first buffer pattern and the reflective electrode. According to some embodiments, the second sub-pixel may further include the first buffer pattern between the base layer and the reflective electrode. According to some embodiments, an average distance between the anode electrode and the reflective electrode in the second sub-pixel may be less than an average distance between the anode electrode and the reflective electrode in the third sub-pixel and greater than an average distance between the anode electrode and the reflective electrode in the first sub-pixel.

Aspects of some embodiments of the present disclosure include a method of fabricating a display device, the method including: forming a buffer pattern in first sub-pixel area on a base layer; forming a reflective electrode over the buffer pattern of the first sub-pixel area and in a second sub-pixel area and a third sub-pixel area of the base layer; forming a planarization layer to cover the reflective electrode and provide a planar upper surface; and forming a light emitting element on the planarization layer. According to some embodiments, in the third sub-pixel area, the reflective electrode is directly on the base layer.

According to some embodiments, forming the buffer pattern may include: forming a first buffer pattern in each of the first to third sub-pixel areas, and a second buffer pattern on the first buffer pattern; forming a photoresist layer in the first sub-pixel area, and removing the second buffer pattern from the second and the third sub-pixel areas; and forming a photoresist layer in the first and the second sub-pixel areas, and removing the first buffer pattern from the third sub-pixel area. The buffer pattern of the first sub-pixel area may include the first buffer pattern and the second buffer pattern.

According to some embodiments, the first buffer pattern may include conductive material, and the second buffer pattern may include insulating material.

At least some of the above and other features of the invention are set out in the claims.

Further details of various embodiments are included in the detailed descriptions and drawings.

### BRIEF DESCRIPTION OF THE DRAWINGS

FIG. 1 is a block diagram illustrating aspects of a display device according to some embodiments.
FIG. 2 is a block diagram illustrating aspects of a sub-pixel of FIG. 1 according to some embodiments.
FIG. 3 is a circuit diagram illustrating aspects of the sub-pixel of FIG. 2 according to some embodiments.
FIG. 4 is a plan view illustrating aspects of further details of a display panel of FIG. 1 according to some embodiments.
FIG. 5 is an exploded perspective view illustrating aspects of a portion of the display panel of FIG. 4 according to some embodiments.
FIG. 6 is a plan view illustrating aspects of a pixel of FIG. 5 according to some embodiments.
FIG. 7 is a sectional view illustrating aspects of a pixel taken along the line I-I' of FIG. 6 according to some embodiments.
FIG. 8 is a sectional view illustrating aspects of the pixel taken along the line I-I' of FIG. 6 according to some embodiments.
FIG. 9 is a sectional view illustrating aspects of the pixel taken along the line I-I' of FIG. 6 according to some embodiments.
FIGS. 10A, 10B, 10C, 10D, 10E, and 10F are sectional views for describing a method of fabricating the display device according to some embodiments.
FIG. 11 is a sectional view illustrating aspects of an emission structure included in any one of the first to third light emitting elements of FIG. 7 according to some embodiments.
FIG. 12 is a sectional view illustrating aspects of an emission structure included in any one of the first to third light emitting elements of FIG. 7 according to some embodiments.
FIG. 13 is a sectional view illustrating further details of the pixel taken along the line I-I' of FIG. 6 according to some embodiments.
FIG. 14 is a plan view illustrating further details of the pixels of FIG. 5 according to some embodiments.
FIG. 15 is a plan view illustrating further details of the pixels of FIG. 5 according to some embodiments.
FIG. 16 is a block diagram illustrating aspects of a display system according to some embodiments.
FIG. 17 is a perspective diagram illustrating an application example of the display system of FIG. 16 according to some embodiments.
FIG. 18 is a diagram illustrating a head-mounted display device of FIG. 17 that is worn on a user according to some embodiments.

### DETAILED DESCRIPTION

Hereinafter, aspects of some embodiments of the present disclosure will be described in more detail with reference to the attached drawings. In the following description, only parts required for understanding of operations in accordance with the present disclosure will be described, and explanation of the other parts may be omitted not to make the gist of the present disclosure unclear. Accordingly, the present disclosure is not limited to the embodiments set forth herein but may be embodied in other types. Rather, these embodiments are provided so that the present disclosure will be thorough and complete, and will fully convey the technical idea of the disclosure to those skilled in the art.

It will be understood that when an element is referred to as being "coupled" or "connected" to another element, it can be directly coupled or connected to the other element or intervening elements may be present therebetween. The terminology used herein is for the purpose of describing particular embodiments only and is not intended to be limiting. In the specification, when an element is referred to as "comprising" or "including" a component, it does not preclude another component but may further include other components unless the context clearly indicates otherwise. In the present disclosure, the phrases "at least one of X, Y, and Z", "at least one of X, Y, or Z" and "at least one selected from the group consisting of X, Y, and Z" may be construed as X only, Y only, Z only, or any combination of two or more of X, Y, and/or Z (for instance, XYZ, XYY, YZ, and ZZ). As used herein, the term "and/or" can include any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element or feature's relationship to another element(s) or feature(s), as illustrated in the drawings. Spatially relative terms are intended to encompass different orientations of an apparatus in use, operation, and/or manufacture in addition to the orientation depicted in the drawings. For example, if the device in the drawings is turned upside down, elements described as "below" or "beneath" other elements or features would then be oriented "above" the other elements or features. Thus, the term "below" can encompass both an orientation of above and below. Furthermore, the device may be otherwise oriented (e.g., rotated 90 degrees or at other orientations), and, as such, the spatially relative descriptors used herein interpreted accordingly.

Herein, aspects of some embodiments will be described in more detail with reference to drawings that are schematic illustrations of embodiments. As such, variations from the shapes of the illustrations as a result, for example, of manufacturing techniques and/or tolerances, are to be expected. Therefore, embodiments disclosed herein should not be construed as limited to the particular illustrated shapes of regions, but are to include deviations in shapes that result from, for instance, manufacturing. As such, the shapes illustrated in the drawings may not illustrate the actual shapes of regions of a device, and, as such, are not intended to be limiting.

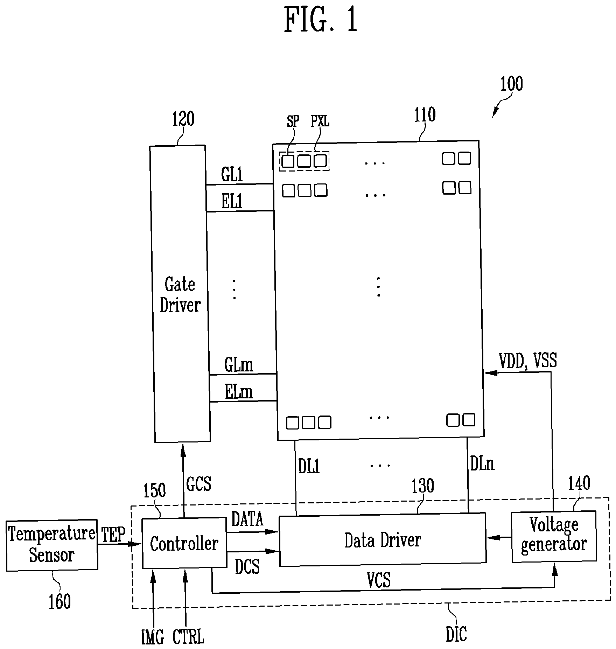

FIG. 1 is a block diagram illustrating aspects of a display device 100 according to some embodiments.

Referring to FIG. 1, the display device 100 may include a display panel 110 (or a display component), a gate driver 120, a data driver 130, a voltage generator 140, and a controller 150.

The display panel 110 may include sub-pixels SP. The sub-pixels SP may be connected to the gate driver 120 through first to m-th gate lines GL1 to GLm. The sub-pixels SP may be connected to the data driver 130 through first to n-th gate lines DL1 to DLn.

Each of the sub-pixels SP may include at least one light emitting element configured to generate light. Accordingly, each of the sub-pixels SP may generate light in a specific color such as red, green, blue, cyan, magenta, or yellow. Two or more sub-pixels among the sub-pixels SP may form one pixel PXL. For example, as illustrated in FIG. 1, three sub-pixels may form one pixel PXL.

The gate driver 120 may be connected to the sub-pixels SP arranged in a row direction through first to m-th gate lines GL1 to GLm. The gate driver 120 may output gate signals to the first to m-th gate lines GL1 to GLm in response to a gate control signal GCS. According to some embodiments, the gate control signal GCS may include a start signal instructing each frame to start, a horizontal synchronization signal for outputting gate signals in synchronization with a timing at which data signals are applied, and the like.

According to some embodiments, there may be further provided first to m-th emission control lines EL1 to ELm connected to the sub-pixels SP in the row direction. In this case, the gate driver 120 may include an emission control driver configured to control the first to m-th emission control lines EL1 to ELm. The emission control driver may operate under the control of the controller 150.

The gate driver 120 may be located on one side of the display panel 110. However, embodiments are not limited to the aforementioned example. For example, the gate driver 120 may be divided into two or more drivers that are physically and/or logically distinguished from each other. The drivers may be located on a first side of the display panel 110 and a second side of the display panel 110 opposite to the first side. As such, the gate driver 120 may be arranged around the display panel 110 in various forms depending on embodiments.

The data driver 130 may be connected to sub-pixels SP arranged in a column direction through the first to n-th data lines DL1 to DLn. The data driver 130 may receive image data DATA and a data control signal DCS from the controller 150. The data driver 130 may operate in response to the data control signal DCS. According to some embodiments, the data control signal DCS may include a source start pulse, a source shift clock, a source output enable signal, and the like.

The data driver 130 may apply, using voltages from the voltage generator 140, data signals having grayscale voltages corresponding to the image data DATA to the first to n-th data lines DL1 to DLn. When a gate signal is applied to each of the first to m-th gate lines GL1 to GLm, data signals corresponding to the image data DATA may be applied to the data lines DL1 to DLm. Hence, the corresponding sub-pixels SP may generate light corresponding to the data signals. As a result, images may be displayed on the display panel 110.

According to some embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 is configured to generate a plurality of voltages and provide the generated voltages to components of the display device 100. For example, the voltage generator 140 may receive an input voltage from an external device provided outside the display device 100, adjust the received voltage, and regulate the adjusted voltage, thus generating a plurality of voltages.

The voltage generator 140 may generate a first power voltage VDD and a second power voltage VSS. The generated first and second power voltages VDD and VSS may be provided to the sub-pixels SP. The first power voltage VDD may have a relatively high voltage level. The second power voltage VSS may have a voltage level lower than the first power voltage VDD. In other embodiments, the first power voltage VDD or the second power voltage VSS may be provided by an external device of the display device 100.

In addition, the voltage generator 140 may generate various voltages. For example, the voltage generator 140 may generate an initialization voltage to be applied to the sub-pixels SP. For example, during a sensing operation for sensing electrical characteristics of transistors and/or light emitting elements of the sub-pixels SP, a certain reference voltage may be applied to each of the first to n-th data lines DL1 to DLn. The voltage generator 140 may generate the reference voltage.

The controller 150 may control overall operations of the semiconductor memory device 100. The controller 150 may receive input image data IMG and a control signal CTRL for controlling an operation of displaying the input image data IMG from an external device. The controller 150 may provide the gate control signal GCS, the data control signal DCS, and the voltage control signal VCS, in response to the control signal CTRL.

The controller 150 may convert the input image data IMG to be suitable for the display device 100 or the display panel 110 and then output image data DATA. According to some embodiments, the controller 150 may align the input image data IMG to be suitable for the sub-pixels SP on a row basis and then output the image data DATA.

Two or more components of the data driver 130, the voltage generator 140, and the controller 150 may be mounted into a single integrated circuit. As illustrated in FIG. 1, the data driver 130, the voltage generator 140, and the controller 150 may be included in a driver integrated circuit DIC. In this case, the data driver 130, the voltage generator 140, and the controller 150 may be components that are functionally separated from each other in the single driver integrated circuit DIC. In other embodiments, at least one of the data driver 130, the voltage generator 140, or the controller 150 may be provided as a component separated from the driver integrated circuit DIC.

The display device 100 may include at least one temperature sensor 160. The temperature sensor 160 is configured to sense a peripheral temperature and generate temperature data TEP indicating the sensed temperature. According to some embodiments, the temperature sensor 160 may be located adjacent to the display panel 110 and/or the driver integrated circuit DIC.

The controller 150 may control various operations of the display device 100 in response to the temperature data TEP. According to some embodiments, the controller 150 may adjust the luminance of an image outputted from the display panel 110 in response to the temperature data TEP. For example, the controller 150 may control components such as the data driver 130 and/or the voltage generator 140, thus adjusting data signals and the first and second power voltages VDD and VSS.

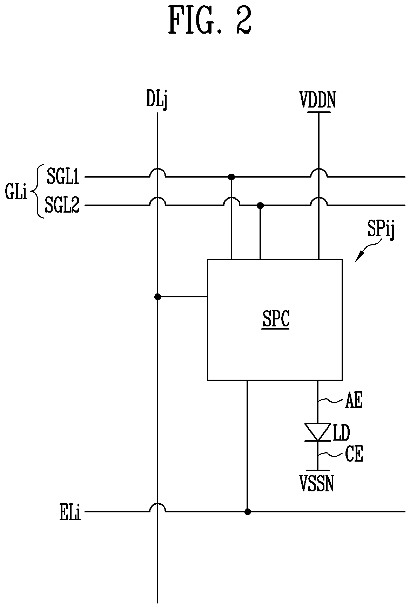

FIG. 2 is a block diagram illustrating aspects of any one of the sub-pixels SP of FIG. 1 according to some embodiments. In FIG. 2, there is illustrated a sub-pixel SPij located on an i-th row (where i is an integer identical to or greater than 1 and identical to or less than m) and a j-th column (where j is an integer identical to or greater than 1 and identical to or less than n).

Referring to FIG. 2, the sub-pixel SPij may include a sub-pixel circuit SPC and a light emitting element LD.

The light emitting element LD is connected between a first power voltage node VDDN and a second power voltage node VSSN. Here, the first power voltage node VDDN may be a node provided to transmit the first power voltage VDD of FIG. 1. The second power voltage node VSSN may be a node provided to transmit the second power voltage VSS.

An anode electrode AE of the light emitting element LD may be connected to the first power voltage node VDDN through the sub-pixel circuit SPC. A cathode electrode CE of the light emitting element LD may be connected to the second power voltage node VSSN. For example, the anode electrode AE of the light emitting element LD may be connected to the first power voltage node VDDN through one or more transistors included in the sub-pixel circuit SPC.

The sub-pixel circuit SPC may be connected to an i-th gate line GLi among the first to m-th gate lines GL1 to GLm of FIG. 1, an i-th emission control line ELi among the first to m-th emission control lines EL1 to ELm of FIG. 1, and a j-th data line DLj among the first to n-th data lines DL1 to DLn of FIG. 1. The sub-pixel circuit SPC is configured to control the light emitting element LD in response to signals received through the aforementioned signal lines.

The sub-pixel circuit SPC may operate in response to a gate signal received through the i-th gate line GLi. The i-th gate line GLi may include one or more sub-gate lines. According to some embodiments, as illustrated in FIG. 2, the i-th gate line GLi may include first and second sub-gate lines SGL1 and SGL2. The sub-pixel circuit SPC may operate in response to gate signals received through the first and second sub-gate lines SGL1 and SGL2. As such, in the case where the i-th gate line GLi includes two or more sub-gate lines, the sub-pixel circuit SPC may operate in response to gate signals received through the corresponding sub-gate lines.

The sub-pixel circuit SPC may operate in response to an emission control signal received through the i-th emission control line ELi. According to some embodiments, the i-th emission control line ELi may include one or more sub-emission control lines. In the case where the i-th emission control line ELi includes two or more sub-emission control lines, the sub-pixel circuit SPC may operate in response to emission control signals received through the corresponding sub-emission control lines.

The sub-pixel circuit SPC may receive a data signal through a j-th data line DLj. The sub-pixel circuit SPC may store a voltage corresponding to the data signal in response to at least one of gate signals received through the first and second sub-gate lines SGL1 or SGL2. The sub-pixel circuit SPC may adjust current flowing from the first power voltage node VDDN to the second power voltage node VSSN through the light emitting element LD according to the stored voltage, in response to the emission control signal received through the i-th emission control line ELi. Therefore, the light emitting element LD may emit light at a luminance corresponding to the data signal.

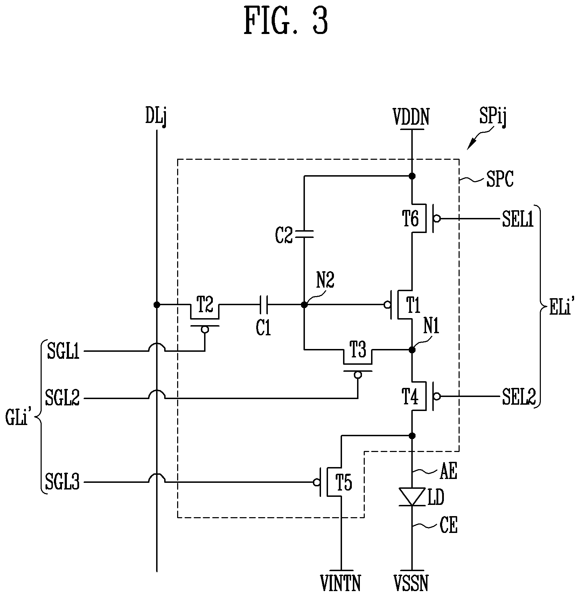

FIG. 3 is a circuit diagram illustrating aspects of the sub-pixel of FIG. 2 according to some embodiments. Referring to FIG. 3, the sub-pixel SPij may include a sub-pixel circuit SPC and a light emitting element LD.

The sub-pixel circuit SPC may be connected to an i-th gate line GLi', an i-th emission control line ELi', and a j-th data line DLj. Compared to the i-th gate line GLi of FIG. 2, the i-th gate line GLi' may further include a third sub-gate line SGL3. Compared to the i-th emission control line ELi of FIG. 2, the i-th emission control line ELi' may include a first sub-emission control line SEL1 and a second sub-emission control line SEL2.

The sub-pixel circuit SPC may include first to sixth transistors T1 to T6 and first and second capacitors C1 and C2.

The first transistor T1 is connected between the first power node VDDN and a first node N1. A gate of the first transistor T1 may be connected to a second node N2. Hence, the first transistor T1 may be turned on depending on the voltage level of the second node N2. The first transistor T1 may be referred to as a driving transistor.

The second transistor T2 may be connected between the j-th data line DLj and the second node N2. A gate of the second transistor T2 may be connected to the first sub-gate line SGL1. Hence, the second transistor T2 may be turned on in response to a gate signal of the first sub-gate line SGL1. The second transistor T2 may be referred to as a switching transistor.

The third transistor T3 may be connected between the first node N1 and the second node N2. A gate of the third transistor T3 may be connected to the second sub-gate line SGL2. Hence, the third transistor T3 may be turned on in response to a gate signal of the second sub-gate line SGL2.

The fourth transistor T4 may be connected between the first node N1 and the anode electrode AE of the light emitting element LD. A gate of the fourth transistor T4 may be connected to a second sub-emission control line SEL2. Hence, the fourth transistor T4 may be turned on in response to an emission control signal of the second sub-emission control line SEL2.

The fifth transistor T5 may be connected between the anode electrode AE of the light emitting element LD and an initialization voltage node VINTN. The initialization voltage node VINTN is configured to transmit an initialization voltage. According to some embodiments, the initialization voltage may be provided by the voltage generator 140 of FIG. 1. In other embodiments, the initialization voltage may be provided by an external device of the display device 100. A gate of the fifth transistor T5 may be connected to the third sub-gate line SGL3. Hence, the fifth transistor T5 may be turned on in response to a gate signal of the third sub-gate line SGL3.

The sixth transistor T6 is connected between the first power voltage node VDDN and the first transistor T1. A gate of the sixth transistor T6 may be connected to the first sub-emission control line SEL1. Hence, the sixth transistor T6 may be turned on in response to an emission control signal of the first sub-emission control line SEL1.

The first capacitor C1 is connected between the second transistor T2 and the second node N2. The second capacitor C2 is connected between the first power voltage node VDDN and the second node N2.

As such, the sub-pixel circuit SPC may include the first to sixth transistors T1 to T6 and the first and second capacitors C1 and C2. However, embodiments are not limited to the foregoing. The sub-pixel circuit SPC may be implemented as any one of various forms of circuits each including a plurality of transistors and one or more capacitors. For example, the sub-pixel circuit SPC may include two transistors and one capacitor. Depending on embodiments of the sub-pixel circuit SPC, the number of sub-gate lines included in the i-th gate line GLi' and the number of sub-emission control lines included in the i-th emission control line ELi' may vary.

The first to sixth transistors T1 to T6 may be formed of P-type transistors. Each of the first to sixth transistors T1 to T6 may be formed of a metal oxide silicon field effect transistor (MOSFET). However, embodiments are not limited to the foregoing. For example, at least one of the first to sixth transistors T1 to T6 may be replaced with to an N-type transistor.

According to some embodiments, the first to sixth transistors T1 to T6 may include an amorphous silicon semiconductor, a monocrystalline silicon semiconductor, a polycrystalline silicon semiconductor, an oxide semiconductor, or the like.

The light emitting element LD may include the anode electrode AE, the cathode electrode CE, and an emission layer. The emission layer may be located between the anode electrode AE and the cathode electrode CE. When emission control signals of the first and second sub-emission control lines SEL1 and SEL2 are enabled to a low level after a data signal transmitted through the j-th data line DLj is reflected in the voltage of the second node N2, the fourth and sixth transistors T4 and T6 may be turned on. Furthermore, the first transistor T1 may be turned on in response to the voltage of the second node N2, so that current may flow from the first power voltage node VDDN to the second power voltage node VSSN. The light emitting element LD may emit light corresponding to the amount of current.

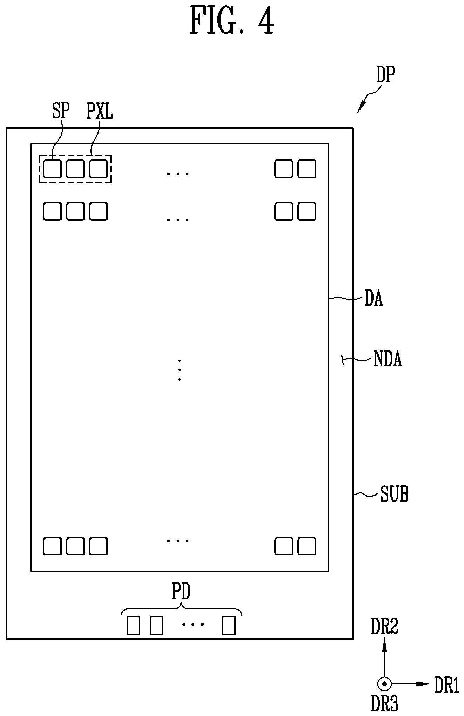

FIG. 4 is a plan view illustrating further details of the display panel DP of FIG. 1 according to some embodiments. Referring to FIG. 4, the display panel DP may include a display area DA and a non-display area NDA. The display panel DP may display an image through the display area DA. The non-display area NDA may be arranged around the display area DA.

The display panel DP may include a substrate SUB, sub-pixels SP, and pads PD.

In the case where the display panel DP is used as a display screen for a head-mounted display (HMD), a virtual reality (VR) device, a mixed reality (MR) device, an augmented reality (AR) device, and the like, the display panel DP may be positioned very close to the eyes of the user. In this case, relatively high-density sub-pixels SP may be required or desired. To increase the pixel density of the sub-pixels SP, the substrate SUB may be provided as a silicon substrate. The sub-pixels SP and/or the display panel DP may be formed on the substrate SUB that is a silicon substrate. The display device 100 (refer to FIG. 1) including the display panel DP formed on the substrate SUB that is a silicon substrate may be referred to as an OLED on Silicon (OLEDoS) display device.

The sub-pixels SP may be located in the display area DA on the substrate SUB. The sub-pixels SP may be arranged in the form of a matrix along a first direction DR1 and a second direction DR2 intersecting with the first direction DR1. However, embodiments are not limited to the aforementioned example. For example, the sub-pixels SP may be arranged in a zigzag pattern in the first direction DR1 and the second direction DR2. For example, the sub-pixels SP may be arranged in the form of a PENTILE^{™}. The first direction DR1 may refer to a row direction, and the second direction DR2 may refer to a column direction.

Two or more sub-pixels among the sub-pixels SP may form one pixel PXL.

Components for controlling the sub-pixels SP may be located in the non-display area NDA on the substrate SUB. For example, connected to the sub-pixels SP, lines such as the first to m-th gate lines GL1 to GLm and the first to n-th data lines DL1 to DLn of FIG. 1 may be located in the non-display area NDA.

At least one of the gate driver 120, the data driver 130, the voltage generator 140, the controller 150 or the temperature sensor 160 of FIG. 1 may be integrated in the non-display area NDA of the display panel DP. According to some embodiments, the gate driver 120 of FIG. 1 may be mounted on the display panel DP and positioned in the non-display area NDA. In other embodiments, the gate driver 120 may be implemented as an integrated circuit separated from the display panel DP. According to some embodiments, the temperature sensor 160 may be positioned in the non-display area NDA to sense the temperature of the display panel DP.

The pads PD may be located in the non-display area NDA on the substrate SUB. The pads PD may be electrically connected to the sub-pixels SP through the lines. For example, the pads PD may be connected to the sub-pixels SP through the first to n-th data lines DL1 to DLn.

The pads PD may interface the display panel DP with other components of the display device 100 (refer to FIG. 1). According to some embodiments, voltages and signals required for the operation of the components included in the display panel DP may be provided through the pads PD from the driver integrated circuit DIC of FIG. 1. For example, the first to n-th data lines DL1 to DLn may be connected to the driver integrated circuit DIC through the pads PD. For example, the first and second power voltages VDD and VSS may be received from the driver integrated circuit DIC through the pads PD. For example, in the case where the gate driver 120 is mounted on the display panel DP, the gate control signal GCS may be transmitted from the driver integrated circuit DIC to the gate driver 120 through the pads PD.

According to some embodiments, a circuit board may be electrically connected to the pads PD by a conductive adhesive component such as an anisotropic conductive film. Here, the circuit board may be a flexible circuit board or flexible film that is made of flexible material. The driver integrated circuit DIC may be mounted on the circuit board and be electrically connected to the pads PD.

According to some embodiments, the display area DA may have various shapes. The display area DA may have a closed-loop shape, including linear and/or curved sides. For example, the display area DA may have shapes such as polygons, circles, semicircles, ellipses, and the like.

According to some embodiments, the display panel DP may have a planar display surface. According to some embodiments, the display panel DP may have a display surface that is least partially rounded. According to some embodiments, the display panel DP is bendable, foldable, or rollable. In the aforementioned cases, the display panel DP and/or the substrate SUB may include materials having flexible properties.

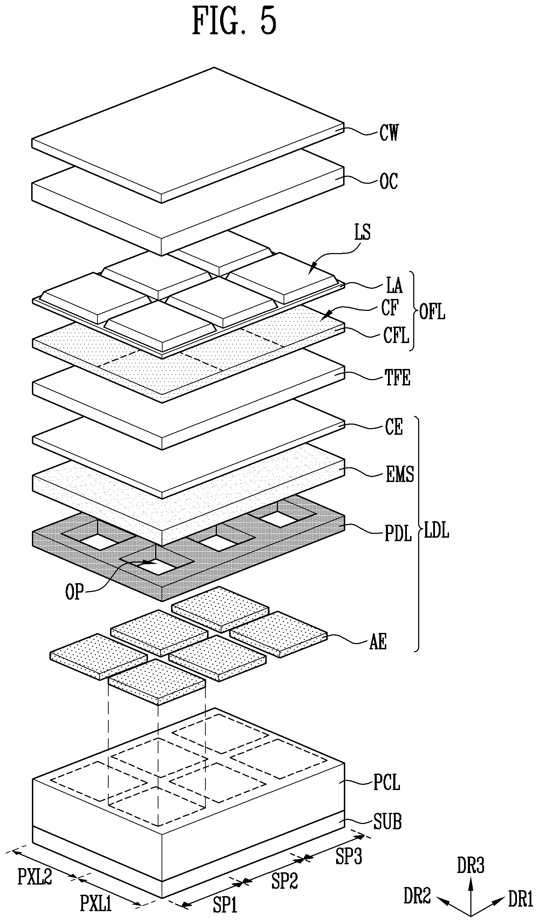

FIG. 5 is an exploded perspective view illustrating a portion of the display panel DP of FIG. 4. In FIG. 5, for the sake of clear and concise explanation, there is schematically illustrated a portion of the display panel DP corresponding to two pixels PXL1 and PXL2 among the pixels PXL of FIG. 4. The remaining portions of the display panel DP corresponding to the other pixels may also be configured in the same manner.

Referring to FIGS. 4 and 5, each of the first and second pixels PXL1 and PXL2 may include first to third sub-pixels SP1, SP2, and SP3. However, embodiments are not limited to the aforementioned example. For example, each of the first and second pixels PXL1 and PXL2 may include four sub-pixels, or may include two sub-pixels.

In FIG. 5 there is illustrated the case where the first to third sub-pixels SP1, SP2, and SP3 have rectangular shapes and the same size when viewed in a third direction DR3 intersecting with the first and second directions DR1 and DR2. However, embodiments are not limited to the aforementioned example. The first to third sub-pixels SP1, SP2, and SP3 may be modified to have various shapes.

The display panel DP may include a substrate SUB, a pixel circuit layer PCL, a light-emitting-element layer LDL, an encapsulation layer TFE, an optical functional layer OFL, an overcoat layer OC, and a cover window CW.

According to some embodiments, the substrate SUB may include a silicon wafer substrate formed through a semiconductor process. The substrate SUB may include semiconductor material suitable for forming circuit elements. For example, the semiconductor material may include silicon, germanium, and/or silicon-germanium. The substrate SUB may be provided from a bulk wafer, an epitaxial layer, a silicon on insulator (SOI) layer, a semiconductor on insulator (SeOl) layer, or the like. According to some embodiments, the substrate SUB may include a glass substrate. According to some embodiments, the substrate SUB may include a polyimide (polyimide) substrate.

The pixel circuit layer PCL may be located on the substrate SUB. The substrate SUB and/or the pixel circuit layer PCL may include insulating layers, and conductive patterns located between the insulating layers. The conductive patterns of the pixel circuit layer PCL may function as at least some of the circuit components, lines, or the like. The conductive patterns may include copper, but embodiments are not limited thereto.

The circuit elements may include respective sub-pixel circuits SPC (refer to FIG. 2) of the first to third sub-pixels SP1, SP2, and SP3. The sub-pixel circuit SPC may include transistors and one or more capacitors. Each transistor may include a semiconductor portion including a source area, a drain area, and a channel area, and a gate electrode overlapping the semiconductor portion. According to some embodiments, in the case where the substrate SUB is formed of a silicon substrate, the semiconductor portion may be included in the substrate SUB, and the gate electrode may be included in the pixel circuit layer PCL as a conductive pattern of the pixel circuit layer PCL. According to some embodiments, in the case where the substrate SUB is formed of a glass substrate or a PI substrate, the semiconductor portion and the gate electrode may be included in the pixel circuit layer PCL. Each capacitor may include electrodes spaced apart from each other. For example, each capacitor may include electrodes spaced apart from each other on a plane defined in the first and second directions DR1 and DR2. For example, each capacitor may include electrodes spaced apart from each other in the third direction DR3 with an insulating layer interposed therebetween.

The lines of the pixel circuit layer PCL may include signal lines connected to each of the first to third sub-pixels SP1, SP2, and SP3, for example, a gate line, an emission control line, and a data line. The lines may further include a line connected to the first power voltage node VDDN of FIG. 2. Furthermore, the lines may further include a line connected to the second power voltage node VSSN of FIG. 2.

The light-emitting-element layer LDL may include an anode electrode AE, a pixel defining layer PDL, an emission structure EMS, and a cathode electrode CE.

The anode electrode AE may be located on the pixel circuit layer PCL. The anode electrode AE may contact circuit elements of the pixel circuit layer PCL. The anode electrode AE may include opaque conductive material capable of reflecting light, but embodiments are not limited thereto.

The pixel defining layer PDL may be located on the anode electrode AE. The pixel defining layer PDL may include an opening OP that exposes a portion of each anode electrode AE. The openings OP in the pixel defining layer PDL may be understood as respective emission areas corresponding to the first to third sub-pixels SP1 to SP3.

According to some embodiments, the pixel defining layer PDL may include inorganic material. In this case, the pixel defining layer PDL may include a plurality of inorganic layers stacked on top of one another. For example, the pixel defining layer PDL may include silicon oxide (SiOₓ) and silicon nitride (SiNₓ). In other embodiments, the pixel defining layer PDL may include organic material. However, the material of the pixel defining layer PDL is not limited to the aforementioned examples.

The emission structure EMS may be located on the anode electrode AE exposed through the opening OP in the pixel defining layer PDL. The emission structure EMS may include an emission layer configured to generate light, an electron transport layer configured to transport electrons, and a hole transport layer configured to transport holes.

According to some embodiments, the emission structure EMS may be charged into the opening OP in the pixel defining layer PDL and be located on an overall surface of an upper portion of the pixel defining layer PDL. In other words, the emission structure EMS may extend over the first to third sub-pixels SP1 to SP3. In this case, at least some of the layers in the emission structure EMS may be interrupted or bent on boundaries between the first to third sub-pixels SP1 to SP3. However, embodiments are not limited to the aforementioned example. For instance, portions of the emission structure EMS corresponding to the first to third sub-pixels SP1 to SP3 may be separated from each other, and each may be located in the corresponding opening OP in the pixel defining layer PDL.

The cathode electrode CE may be located on the emission structure EMS. The cathode electrode CE may extend over the first to third sub-pixels SP1 to SP3. As such, the cathode electrode CE may be provided as a common electrode for the first to third sub-pixels SP1 to SP3.

The cathode electrode CE may be a thin-film metal layer having a thickness allowing light emitted from the emission structure EMS to pass therethrough. The cathode electrode CE may be made of a metal material having a relatively small thickness, or a transparent conductive material. According to some embodiments, the cathode electrode CE may include at least one of various transparent conductive materials including indium tin oxide, indium zinc oxide, indium tin zinc oxide, aluminium zinc oxide, gallium zinc oxide, zinc tin oxide, or gallium tin oxide. According to some embodiments, the cathode electrode CE may include at least one of silver (Ag), magnesium (Mg), or a compound thereof. However, the material of the cathode electrode CE is not limited to the foregoing example.

Any one of the anode electrodes AE, a portion of the emission structure EMS that overlap the any one anode electrode AE, and a portion of the cathode electrode CE that overlaps the portion of the emission structure EMS can be understood as constituting one light emitting element LD (refer to FIG. 2). In other words, each of the light emitting elements of the first to third sub-pixels SP1 to SP3 may include one anode electrode, a portion of the emission structure EMS that overlaps the one anode electrode, and a portion of the cathode electrode CE that overlaps the portion of the emission structure. In each of the first to third sub-pixels SP1 to SP3, holes injected from the anode electrode AE and electrons injected from the cathode electrode CE are transported into the emission layer of the emission structure EMS, thus forming excitons. When the excitons make a transition from an excited state to a ground state, light can be generated. Depending on the amount of current flowing through the emission layer, the luminance of light may be determined. Depending on the configuration of the emission layer, the wavelength range of light to be generated may be determined.

The encapsulation layer TFE may be located on the cathode electrode CE. The encapsulation layer TFE may cover the light-emitting-element layer LDL and/or the pixel circuit layer PCL. The encapsulation layer TFE may be configured to prevent or reduce instances of contaminants such as oxygen, and/or water or the like penetrating into the light-emitting-element layer LDL. According to some embodiments, the encapsulation layer TFE may include a structure formed by alternately stacking one or more inorganic layers and one or more organic layers. For example, the inorganic layer may include, for example, silicon nitride, silicon oxide, or silicon oxynitride (SiOₓN_{y}). For example, the organic layer may include organic insulating material such as polyacrylates resin, epoxy resin, phenolic resin, polyamides resin, polyimides resin, unsaturated polyesters resin, polyphenylenes resin, polyphenylene sulfides resin, or benzocyclobutene (BCB). However, the materials of the organic layer and the inorganic layer of the encapsulation layer TFE are not limited to the aforementioned examples.

The encapsulation layer TFE may further include a thin film, including aluminium oxide (AlOₓ), to enhance the encapsulation efficiency of the encapsulation layer TFE. The thin film including aluminium oxide may be positioned on an upper surface of the encapsulation layer TFE that faces the optical functional layer OFL and/or under a lower surface of the encapsulation layer TFE that faces the light-emitting-element layer LDL.

The thin film including aluminium oxide may be formed through an atomic layer deposition (ALD) method. However, embodiments are not limited to the aforementioned example. The encapsulation layer TFE may further include a thin film formed of at least one of various materials suitable for enhancing the encapsulation efficiency.

The optical functional layer OFL may be located on the encapsulation layer TFE. The optical functional layer OFL may include a color filter layer CFL and a lens array LA.

The color filter layer CFL may be located between the encapsulation layer TFE and the lens array LA. The color filter layer CFL may be configured to filter light emitted from the emission structure EMS to selectively output light in a wavelength range or color corresponding to each sub-pixel. The color filter layer CFL may include color filters CF respectively corresponding to the first to third sub-pixels SP1 to SP3. Each of the color filters CF allows light within a wavelength range corresponding to the related sub-pixel to pass therethrough. For example, the color filter that corresponds to the first sub-pixel SP1 allows light in a red color to pass therethrough, the color filter that corresponds to the second sub-pixel SP2 allows light in a green color to pass therethrough, and the color filter that corresponds to the third sub-pixel SP3 allows light in a blue color to pass therethrough. Depending on the light emitted from the emission structure EMS of each sub-pixel, at least some of the color filters CF may be omitted.

The lens array LA may be located on the color filter layer CFL. The lens array LA may include lenses LS that respectively correspond to the first to third sub-pixels SP1 to SP3. Each of the lenses LS may output and direct light emitted from the emission structure EMS along an intended path, thus enhancing the light output efficiency. The lens array LA may have a relatively high refractive index. For example, the lens array LA may have a higher refractive index than the overcoat layer OC. According to some embodiments, the lenses LS may include organic material. According to some embodiments, the lenses LS may include acrylate material. However, the material of the lenses LS is not limited to the foregoing example.

According to some embodiments, compared to the openings OP of the pixel defining layer PDL, at least some of the color filters CF of the color filter layer CFL and at least some of the lenses LS of the lens array LA may be shifted in a direction parallel to the plane defined in the first and second directions DR1 and DR2. Specifically, in a central area of the display area DA, the center of each color filter and the center of each lens may be aligned or overlapped with the center of the corresponding opening OP of the pixel defining layer PDL. For example, in the central area of the display area DA, each opening OP of the pixel defining layer PDL may completely overlap the corresponding color filter of the color filter layer CFL and the corresponding lens of the lens array LA. In an area of the display area DA that is adjacent to the non-display area NDA, the center of the color filter and the center of the lens LS may be shifted in a plane direction from the center of the corresponding opening OP of the pixel defining layer PDL when viewed in the third direction DR3. For example, in the area adjacent to the non-display area NDA within the display area DA, each opening OP of the pixel defining layer PDL may partially overlap the corresponding color filter of the color filter layer CFL and the corresponding lens of the lens array LA. Accordingly, light emitted from the emission structure EMS in the central portion of the display area DA may be efficiently outputted in the normal direction of the display surface. Light emitted from the emission structure EMS around the perimeter of the display area DA may be efficiently outputted in a direction inclined at a certain angle with respect to the normal direction of the display surface.

The overcoat layer OC may be located on the lens array LA. The overcoat layer OC may cover the optical functional layer OFL, the encapsulation layer TFE, the emission structure EMS, and/or the pixel circuit layer PCL. The overcoat layer OC may include various materials suitable for protecting underlying layers from foreign substances such as dust, water, or the like. For example, the overcoat layer OC may include at least one of an inorganic insulating layer or an organic insulating layer. For example, the overcoat layer OC may include epoxy, but embodiments are not limited thereto. The overcoat layer OC may have a lower refractive index than the lens array LA.

The cover window CW may be located on the overcoat layer OC. The cover window CW may be configured to protect underlying layers. The cover window CW may have a higher refractive index than the overcoat layer OC. The cover window CW may include glass, but embodiments are not limited thereto. For example, the cover window CW may be an encapsulation glass layer configured to protect components located thereunder. In other embodiments, the cover window CW may be omitted.

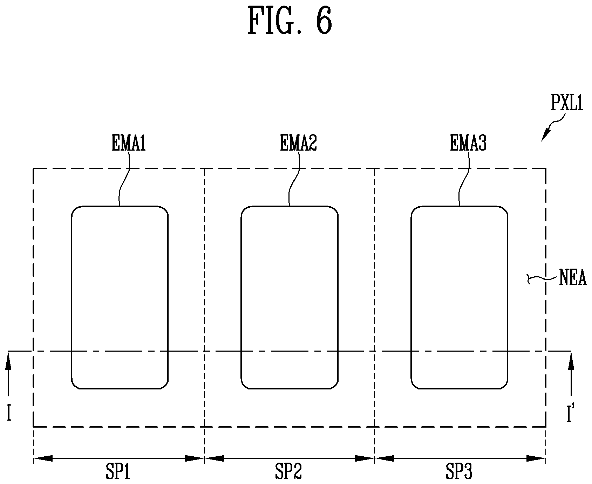

FIG. 6 is a plan view illustrating further details of any one of the pixels of FIG. 5 according to some embodiments. In FIG. 6, for the sake of clear and concise explanation, the first pixel PXL1 of the first and second pixels PXL1 and PXL2 of FIG. 5 are schematically depicted. The other pixels may be configured in the same manner as the first pixel PXL1.

Referring to FIGS. 5 and 6, the first pixel PXL1 may include first to third sub-pixels SP1 to SP3 arranged in the first direction DR1.

The first sub-pixel SP1 may include a first emission area EMA1 and a non-emission area NEA formed around the first emission area EMA1. The second sub-pixel SP2 may include a second emission area EMA2 and a non-emission area NEA formed around the second emission area EMA2. The third sub-pixel SP3 may include a third emission area EMA3 and a non-emission area NEA formed around the third emission area EMA3.

The first emission area EMA1 may be an area where light is emitted from a portion of the emission structure EMS (refer to FIG. 5) that corresponds to the first sub-pixel SP1. The second emission area EMA2 may be an area where light is emitted from a portion of the emission structure EMS that corresponds to the second sub-pixel SP2. The third emission area EMA3 may be an area where light is emitted from a portion of the emission structure EMS that corresponds to the third sub-pixel SP3. As described with reference to FIG. 5, each emission area may be understood as the opening OP of the pixel defining layer PDL corresponding to each of the first to third sub-pixels SP1 to SP3.

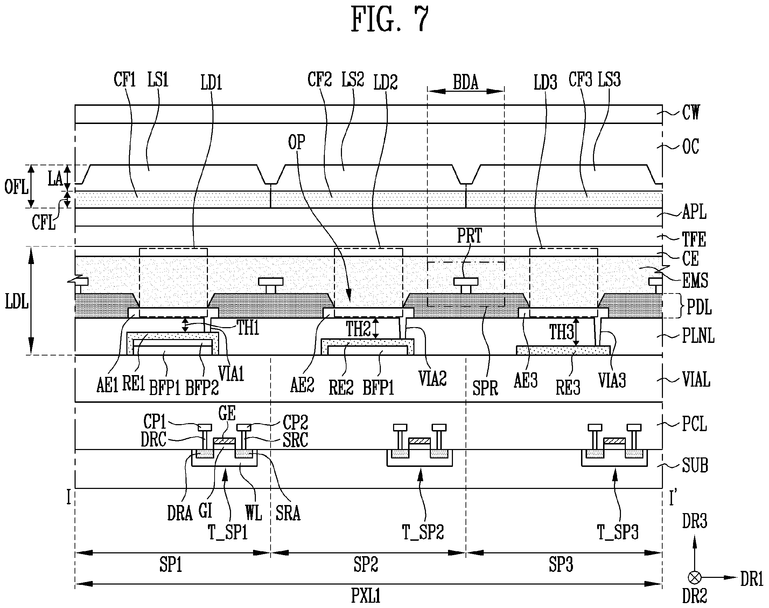

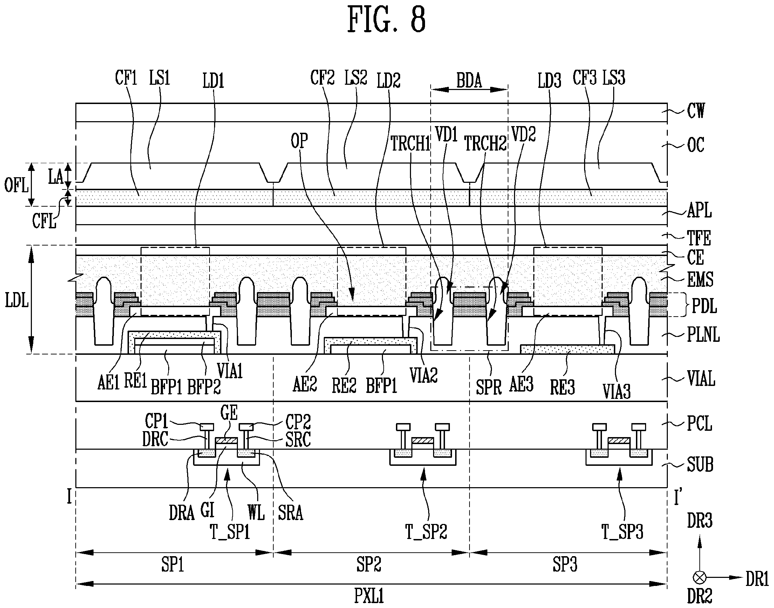

FIG. 7 is a sectional view illustrating aspects of the pixel taken along the line I-I' of FIG. 6. FIG. 8 is a sectional view illustrating further details of the pixel taken along the line I-I' of FIG. 6. In FIG. 8, there is illustrated aspects of a separator SPR. The embodiments depicted in FIG. 8 except the separator SPR are substantially the same as the embodiments depicted in FIG. 7.

Referring to FIG. 7, there are provided the substrate SUB and the pixel circuit layer PCL located on the substrate SUB.

The substrate SUB may include a silicon wafer substrate formed through a semiconductor process. For example, the substrate SUB may include silicon, germanium, and/or silicon-germanium.

The pixel circuit layer PCL may be located on the substrate SUB. The substrate SUB and the pixel circuit layer PCL may include respective circuit elements of the first to third sub-pixels SP1 to SP3. For example, the substrate SUB and the pixel circuit layer PCL may include a transistor T_SP1 of the first sub-pixel SP1, a transistor T_SP2 of the second sub-pixel SP2, and a transistor T_SP3 of the third sub-pixel SP3. The transistor T_SP1 of the first sub-pixel SP1 may be any one of the transistors included in the sub-pixel circuit SPC (refer to FIG. 2) of the first sub-pixel SP1. The transistor T_SP2 of the second sub-pixel SP2 may be any one of the transistors included in the sub-pixel circuit SPC of the second sub-pixel SP2. The transistor T_SP3 of the third sub-pixel SP3 may be any one of the transistors included in the sub-pixel circuit SPC of the third sub-pixel SP3. In FIG. 7, one of the transistors of each sub-pixel is illustrated for the sake of clear and concise explanation, and the remaining circuit circuits are omitted.

The transistor T_SP1 of the first sub-pixel SP1 may include a source area SRA, a drain area DRA, and a gate electrode GE.

The source area SRA and the drain area DRA may be located in the substrate SUB. Formed through an ion injection process, a well WL may be located in the substrate SUB. The source area SRA and the drain area DRA may be spaced apart from each other in the well WL. An area between the source area SRA and the drain area DRA in the well WL may be defined as a channel area.

The gate electrode GE may overlap the channel area between the source area SRA and the drain area DRA, and may be located in the pixel circuit layer PCL. The gate electrode GE may be spaced apart from the well WL or the channel area by an insulating material such as a gate insulating layer GI. The gate electrode GE may include conductive material.

A plurality of layers included in the pixel circuit layer PCL may include insulating layers and conductive patterns located between the insulating layers. The conductive patterns may include first and second conductive patterns CP1 and CP2. The first conductive pattern CP1 may be electrically connected to the drain area DRA through a drain connector DRC passing through one or more insulating layers. The second conductive pattern CP2 may be electrically connected to the source area SRA through a source connector SRC passing through one or more insulating layers.

As the gate electrode GE and the first and second conductive patterns CP1 and CP2 are connected to other circuit elements and/or lines, the transistor T_SP1 of the first sub-pixel SP1 may be provided as one of the transistors of the first sub-pixel SP1.

Each of the transistor T_SP2 of the second sub-pixel SP2 and the transistor T_SP3 of the third sub-pixel SP3 may be configured in the same manner as the transistor T_SP1 of the first sub-pixel SP1.

As such, the substrate SUB and the pixel circuit layer PCL may include respective circuit elements of the first to third sub-pixels SP1 to SP3.

A via layer VIAL (or a base layer) may be located on the pixel circuit layer PCL. The via layer VIAL may cover the pixel circuit layer PCL, and have an overall even surface. The via layer VIAL is configured to planarize stepped portions on the pixel circuit layer PCL. The via layer VIAL may include at least one of silicon oxide (SiOₓ), silicon nitride (SiNₓ), or silicon carbon nitride (SiCN), but embodiments are not limited thereto.

The light-emitting-element layer LDL may be located on the via layer VIAL. The light-emitting-element layer LDL may include first to third reflective electrodes RE1 to RE3, a planarization layer PLNL, first to third anode electrodes AE1 to AE3, a pixel defining layer PDL, an emission structure EMS, and a cathode electrode CE.

The first to third reflective electrodes RE1 to RE3 may be respectively located in the first to third sub-pixels SP1 to SP3 on the via layer VIAL. Each of the first to third reflective electrodes RE1 to RE3 may contact a circuit element located in the pixel circuit layer PCL through a corresponding via passing through the via layer VIAL.

The first to third reflective electrodes RE1 to RE3 may function as full mirrors provided to reflect light emitted from the emission structure EMS toward the display surface (or the cover window CW). The first to third reflective electrodes RE1 to RE3 may include metallic materials suitable for reflecting light. The first to third reflective electrodes RE1 to RE3 may include at least one of aluminium (Al), silver (Ag), magnesium (Mg), platinum (Pt), palladium (Pd), gold (Au), nickel (Ni), neodymium (Nd), iridium (Ir), chromium (Cr), titanium (Ti), or an alloy of two or more materials selected from among the aforementioned materials.

The first to third reflective electrodes RE1 to RE3 may have the same thickness. For example, the thickness of each of the first to third reflective electrodes RE1 to RE3 may range from approximately 700 Å to approximately 1000 Å, or may be approximately 850 Å.

According to some embodiments, a first buffer pattern BFP1 (or a connection electrode) may be located under at least one of the first to third reflective electrodes RE1 to RE3. The first buffer pattern BFP1 may include conductive material and enhance electrical connection characteristics between the corresponding reflective electrode and the corresponding circuit element of the pixel circuit layer PCL. The first buffer pattern BFP1 may include materials such as titanium (Ti), titanium nitride (TiN), tantalum nitride (TaN), but embodiments are not limited thereto. The first buffer pattern BFP1 may have a multilayer structure.

Referring to FIG. 7, for example, in the first sub-pixel SP1, the first buffer pattern BFP1 may be located between the first reflective electrode RE1 and the via layer VIAL. Furthermore, in the second sub-pixel SP2, the first buffer pattern BFP1 may be located between the second reflective electrode RE2 and the via layer VIAL. In the third sub-pixel SP3, the first buffer pattern BFP1 is not located between the third reflective electrode RE3 and the via layer VIAL. The third reflective electrode RE3 may be directly located on the via layer VIAL.

According to some embodiments, a second buffer pattern BFP2 (or a buffer pattern) may be located under at least one of the first to third reflective electrodes RE1 to RE3. The second buffer pattern BFP2 may include insulating material. For example, the second buffer pattern BFP2 includes inorganic material such as silicon nitride (SiNₓ), silicon carbon nitride, silicon oxide (SiOₓ), but embodiments are not limited thereto. As the second buffer pattern BFP2 (and the first buffer pattern BFP1) is located, the height of the corresponding reflective electrode in the third direction DR3 may be adjusted.

Referring to FIG. 7, for example, in the first sub-pixel SP1, the second buffer pattern BFP2 may be located between the first reflective electrode RE1 and the first buffer pattern BFP1 to adjust the height of the first reflective electrode RE1. In the second sub-pixel SP2, the second buffer pattern BFP2 is not located between the second reflective electrode RE2 and the first buffer pattern BFP1. The second reflective electrode RE2 may be directly located on the first buffer pattern BFP1.

The first to third reflective electrodes RE1 to RE3 may function as full mirrors, and the cathode electrode CE may function as a half mirror. Light emitted from the emission layer of the emission structure EMS may be amplified, at least partially, by reciprocating between the corresponding reflective electrode and the cathode electrode CE. The amplified light can be output through the cathode electrode CE. In this way, the distance between each reflective electrode and the cathode electrode CE can be understood as a resonant distance for the light emitted from the emission layer of the corresponding emission structure EMS.

For example, the first to third sub-pixels SP1 to SP3 may respectively correspond to red, green, and blue. The distance between the first reflective electrode RE1 and the cathode electrode CE may be less than the distance between the second reflective electrode RE2 and the cathode electrode CE. The distance between the second reflective electrode RE2 and the cathode electrode CE may be less than the distance between the third reflective electrode RE3 and the cathode electrode CE.

The first sub-pixel SP1 may have a resonant distance shorter than the second and third sub-pixels SP2 and SP3 by the first buffer pattern BFP1 and the second buffer pattern BFP2. Likewise, the second sub-pixel SP2 may have a resonant distance shorter than the third sub-pixel SP3 by the first buffer pattern BFP1. As such, the adjusted resonant distance may make it possible for light in a specific wavelength range (e.g., red color, or green color) to be efficiently amplified. Consequently, each of the first sub-pixel SP1 and the second sub-pixel SP2 may effectively and efficiently output light in the corresponding wavelength range.

In FIG. 7, there is illustrated the case where the first buffer pattern BFP1 is provided in the first and second sub-pixels SP1 and SP2 but is not provided in the third sub-pixel SP3, but embodiments according to the present disclosure are not limited thereto. For example, the first buffer pattern BFP1 (or the connection electrode) may be provided in the third sub-pixel SP3.

In FIG. 7, there is illustrated the case where the second buffer pattern BFP2 is provided in the first sub-pixel SP1 but is not provided in the second and third sub-pixels SP2 and SP3, but embodiments are not limited thereto. For example, the second buffer pattern BFP2 may be provided in at least one of the second or third sub-pixels SP2 or SP3 so that the resonant distance of at least one of the second or third sub-pixels SP2 or SP3 can be adjusted.

According to some embodiments, the thickness of the second buffer pattern BFP2 (or the thickness with respect to the third direction DR3) may be substantially the same as the thickness of the first buffer pattern BFP1. For example, the thickness of each of the first buffer pattern BFP1 and the second buffer pattern BFP2 may range from approximately 400 Å to approximately 600 Å, or may be approximately 500 Å.

To planarize the stepped portions between the first to third reflective electrodes RE1 to RE3, the planarization layer PLNL may be located on the via layer VIAL and the first to third reflective electrodes RE1 to RE3. The planarization layer PLNL may cover overall surfaces of the first to third reflective electrodes RE1 to RE3 and the via layer VIAL, and have an even surface. The planarization layer PLNL may include insulating material. For example, the planarization layer PLNL may include inorganic material such as silicon oxide (SiOₓ) and silicon nitride (SiNₓ), but embodiments are not limited thereto.

On the planarization layer PLNL, the first to third anode electrodes AE1 to AE3 may be located, overlapping the first to third reflective electrodes RE1 to RE3, respectively. The first to third anode electrodes AE1 to AE3 may have shapes similar to the first to third emission areas EMA1 to EMA3 of FIG. 6 when viewed in the third direction DR3. The first to third anode electrodes AE1 to AE3 are respectively connected to the first to third reflective electrodes RE1 to RE3. The first anode electrode AE1 may be connected to the first reflective electrode RE1 through a first via VIA1 passing through the planarization layer PLNL. The second anode electrode AE2 may be connected to the second reflective electrode RE2 through a second via VIA2 passing through the planarization layer PLNL. The third anode electrode AE3 may be connected to the third reflective electrode RE3 through a third via VIA3 passing through the planarization layer PLNL.

According to some embodiments, the first to third anode electrodes AE1 to AE3 may include at least one of transparent conductive materials such as indium tin oxide (ITO), indium zinc oxide (IZO), zinc oxide (ZnOₓ), indium gallium zinc oxide (IGZO), or indium tin zinc oxide (ITZO). However, the material of the first to third anode electrodes AE1 to AE3 is not limited to the aforementioned example. For example, the first to third anode electrodes AE1 to AE3 may include titanium nitride.

The first to third anode electrodes AE1 to AE3 may have the same thickness. For example, the thickness of each of the first to third anode electrodes AE1 to AE3 may range from approximately 700 Å to approximately 1000 Å, or may be approximately 850 Å.

According to some embodiments, a distance TH1 (or an average distance, a shortest distance) between the first anode electrode AE1 and the first reflective electrode RE1 in the first sub-pixel SP1 may be less than a distance TH2 between the second anode electrode AE2 and the second reflective electrode RE2 in the second sub-pixel SP2. The distance TH2 (or an average distance, a shortest distance) between the second anode electrode AE2 and the second reflective electrode RE2 in the second sub-pixel SP2 may be less than a distance TH3 between the third anode electrode AE3 and the third reflective electrode RE3 in the third sub-pixel SP3.

For example, an average thickness (i.e., the distance TH2) of the planarization layer PLNL in the second sub-pixel SP2 may be approximately 1.4 times to approximately 1.7 times an average thickness (i.e., the distance TH1) of the planarization layer PLNL in the first sub-pixel SP1. An average thickness (i.e., the distance TH3) of the planarization layer PLNL in the third sub-pixel SP3 may be approximately 1.9 times to approximately 2.4 times an average thickness (i.e., the distance TH1) of the planarization layer PLNL in the first sub-pixel SP1. For example, the average thickness (i.e., the distance TH1) of the planarization layer PLNL in the first sub-pixel SP1 may range from approximately 700 Å to approximately 1000 Å, or may be approximately 850 Å. The average thickness (i.e., the distance TH2) of the planarization layer PLNL in the second sub-pixel SP2 may range from approximately 1200 Å to approximately 1500 Å, or may be approximately 1350 Å. The average thickness (i.e., the distance TH3) of the planarization layer PLNL in the third sub-pixel SP3 may range from approximately 1600 Å to approximately 2000 Å, or may be approximately 1800 Å.

The pixel defining layer PDL may be located on the planarization layer PLNL and portions of the first to third anode electrodes AE1 to AE3. The pixel defining layer PDL may include openings OP that expose respective portions of the first to third anode electrodes AE1 to AE3. The openings OP in the pixel defining layer PDL may define the respective emission areas of the first to third sub-pixels SP1 to SP3. As such, the pixel defining layer PDL may be placed in the non-emission area NEA of FIG. 6 and define the first to third emission areas EMA1 to EMA3 of FIG. 6.

According to some embodiments, the pixel defining layer PDL may include a plurality of inorganic insulating layers. Each of the inorganic insulating layers may include at least one of silicon oxide (SiOₓ) or silicon nitride (SiNₓ). Referring to FIG. 8, for example, the pixel defining layer PDL may include first to third inorganic insulating layers that are successively stacked. The first to third inorganic insulating layers may respectively include silicon nitride, silicon oxide, and silicon nitride. However, embodiments are not limited to the aforementioned example. The first to third insulating layers may have a stepped shape in an area adjacent to each of the openings OP.

A separator SPR may be provided in a boundary area BDA between the adjacent sub-pixels. In other words, the separator SPR may be provided in each of the boundary areas between the sub-pixels SP.

The separator SPR may result in creation of discontinuous portions in the emission structure EMS in the boundary area BDA. For example, the emission structure EMS may be interrupted or bent in the boundary area BDA by the separator SPR.

The separator SPR may be provided in or on the pixel defining layer PDL.

According to some embodiments, the pixel defining layer PDL may include a protrusion pattern PRT as the separator SPR in the boundary area BDA.

As illustrated in FIG. 7, the protrusion pattern PRT that is additionally stacked on the pixel defining layer PDL may be provided in the boundary area BDA. The width of the protrusion pattern PRT may increase upward (or in the third direction DR3). For example, the protrusion pattern PRT may include inorganic insulating patterns. The uppermost inorganic insulating pattern among the inorganic insulating patterns may have a width greater than the immediately underlying inorganic insulating pattern. For example, in the boundary area BDA, the first to third inorganic insulating patterns may be successively stacked from the pixel defining layer PDL. The uppermost third inorganic insulating pattern may have a width greater than the second inorganic insulating pattern. For example, the protrusion pattern PRT may have a "T"-shaped or "I"-shaped cross-section in the boundary area BDA. Depending on the shape of the protrusion pattern PRT, a plurality of layers included in the emission structure EMS may be at least partially interrupted or bent in the boundary area BDA.

The separator SPR may be modified in various ways to allow the emission structure EMS to have the discontinuous portions in the boundary area BDA. According to some embodiments, the pixel defining layer PDL may include one or more trenches TRCH1 and TRCH2 in the boundary area BDA as the separator SPR.

As illustrated in FIG. 8, the one or more trenches TRCH1 and TRCH2 may pass through the pixel defining layer PDL and partially pass through the planarization layer PLNL. In other embodiments, the one or more trenches TRCH1 and TRCH2 may pass through the pixel defining layer PDL and the planarization layer PLNL and partially pass through the via layer VIAL. In other embodiments, the one or more trenches TRCH1 and TRCH2 may pass at least partially through the planarization layer PLNL and/or the via layer VIAL, and a portion of the pixel defining layer PDL may be located in the one or more trenches TRCH1 and TRCH2.

For example, two trenches TRCH1 and TRCH2 separated from each other may be provided in the boundary area BDA. For example, in the boundary area BDA between the second sub-pixel SP2 and the third sub-pixel SP3, the first trench TRCH1 and the second trench TRCH2 may be located, the first trench TRCH1 may be arranged along a periphery of the second sub-pixel SP2, and the second trench TRCH2 may be arranged along a peripheral of the third sub-pixel SP3. In the case where the trenches TRCH1 and TRCH2 are separated from each other, the width of each of the trenches TRCH1 and TRCH2 remains constant, and the discontinuous portion of the emission structure EMS in the boundary area BDA may be made uniform. In the case where the trenches TRCH1 and TRCH2 are connected to each other, the width of a connected portion between the trenches TRCH1 and TRCH2 may be greater than that of other portions, the discontinuous portion of the emission structure EMS may become non-uniform, and the characteristics of the emission structure EMS may become uneven.

In FIG. 8, there is illustrated the case where the two trenches TRCH1 and TRCH2 are provided in the boundary area BDA. However, embodiments are not limited to the foregoing. For example, the pixel defining layer PDL may include one trench in the boundary area BDA. Alternatively, the pixel defining layer PDL may include three or more trenches in the boundary area BDA.

Due to the first and second trenches TRCH1 and TRCH2, discontinuous portions such as a first void VD1 and a second void VD2 in the boundary area BDA may be formed in the emission structure EMS. Some of the plurality of layers stacked in the emission structure EMS may be interrupted or bent by the first and second voids VD1 and VD2. For example, at least one charge generation layer included in the emission structure EMS may be interrupted by the first and second voids VD1 and VD2. As such, due to the first and second trenches TRCH1 and TRCH2, portions of the emission structure EMS included in the first to third sub-pixels SP1 to SP3 are at least partially separated from each other.

In FIG. 8, there is illustrated the case where the first and second voids VD1 and VD2 are formed in the emission structure EMS in the boundary area BDA, but this is illustrative, and embodiments are not limited thereto. For example, a valley having a concave shape may be formed in the emission structure EMS in the boundary area BDA. Depending on the shapes of the first and second trenches TRCH1 and TRCH2, the discontinuous portions formed in the emission structure EMS may be changed in various ways.

According to some embodiments, the emission structure EMS may be formed through a process such as vacuum deposition, or inkjet printing. In this case, the same materials as the emission structure EMS may be positioned on bottom surfaces adjacent to the via layer VIAL in the first and second trenches TRCH1 and TRCH2.

The emission structure EMS may be located on the anode electrode AE exposed through the opening OP in the pixel defining layer PDL. The emission structure EMS may be charged into the opening OP of the pixel defining layer PDL, and be arranged over the overall areas of the first to third sub-pixels SP1 to SP3. As described above, the emission structure EMS may be at least partially interrupted or bent in the boundary area BDA by the separator SPR. Consequently, during the operation of the display panel DP, current leaking from each of the first to third sub-pixels SP1 to SP3 to the adjacent sub-pixel through the layers included in the emission structure EMS may be reduced. As a result, the first to third light emitting elements LD1 to LD3 may be operated with relatively high reliability.

The cathode electrode CE may be located on the emission structure EMS. The cathode electrode CE may be provided in common in the first to third sub-pixels SP1 to SP3. The cathode electrode CE may function as a half mirror, partially transmitting and partially reflecting light emitted from the emission structure EMS.

The first anode electrode AE1, the portion of the emission structure EMS that overlaps the first anode electrode AE1, the portion of the cathode electrode CE that overlaps the first anode electrode AE1 may form the first light emitting element LD1. The second anode electrode AE2, the portion of the emission structure EMS that overlaps the second anode electrode AE2, the portion of the cathode electrode CE that overlaps the second anode electrode AE2 may form the second light emitting element LD2. The third anode electrode AE3, the portion of the emission structure EMS that overlaps the third anode electrode AE3, the portion of the cathode electrode CE that overlaps the third anode electrode AE3 may form the third light emitting element LD3.

The encapsulation layer TFE may be located on the cathode electrode CE. The encapsulation layer TFE may prevent or reduce instances of contaminants such as oxygen and/or water or the like penetrating into the light-emitting-element layer LDL.

The optical functional layer OFL may be located on the encapsulation layer TFE. According to some embodiments, the optical functional layer OFL may be attached to the encapsulation layer TFE through an adhesive layer APL. For example, the optical functional layer OFL may be fabricated through a separate process and attached to the encapsulation layer TFE by the adhesive layer APL. The adhesive layer APL may further perform a function of protecting underlying layers including the encapsulation layer TFE.

The optical functional layer OFL may include a color filter layer CFL and a lens array LA. The color filter layer CFL may include first to third color filters CF1 to CF3 respectively corresponding to the first to third sub-pixels SP1 to SP3. The first to third color filters CF1 to CF3 may transmit light in different wavelength ranges. For example, the first to third color filters CF1 to CF3 may respectively transmit red light, green light, and blue light.

According to some embodiments, the first to third color filters CF1 to CF3 may partially overlap each other in the boundary area BDA. In other embodiments, the first to third color filters CF1 to CF3 may be spaced apart from each other, and a black matrix may be provided between the first to third color filters CF1 to CF3

The lens array LA may be located on the color filter layer CFL. The lens array LA may include first to third lenses LS1 to LS3 that respectively correspond to the first to third sub-pixels SP1 to SP3. The first to third lenses LS1 to LS3 may respectively direct light emitted from the first to third light emitting elements LD1 to LD3 in intended paths, thus enhancing the light output efficiency.

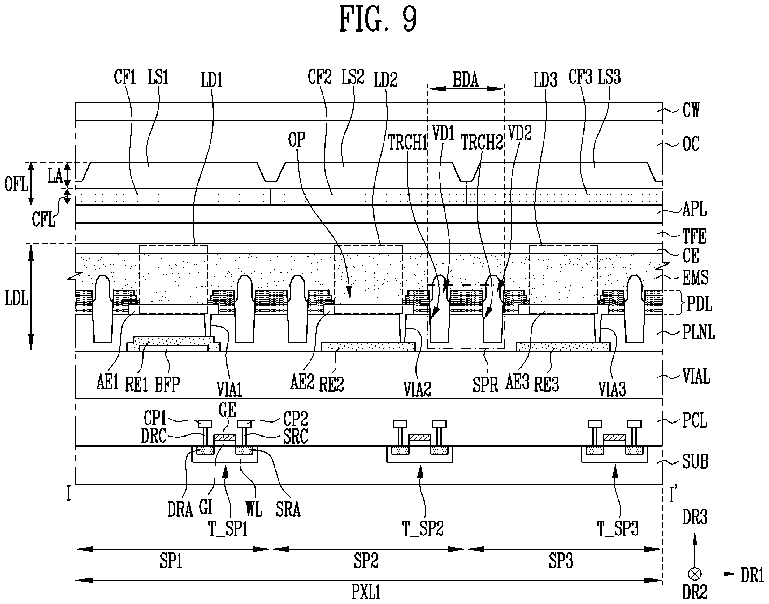

FIG. 9 is a sectional view illustrating further details of the pixel taken along the line I-I' of FIG. 6 according to some embodiments.

Referring to FIGS. 8 and 9, the embodiments depicted in FIG. 9 except a buffer pattern BFP may be substantially identical or similar to the embodiments depicted in FIG. 8. Therefore, some repetitive explanation thereof may be omitted.

According to some embodiments, the buffer pattern BFP may be located under at least one of the first to third reflective electrodes RE1 to RE3.

The buffer pattern BFP may include at least one of the first buffer pattern BFP1 or the second buffer pattern BFP2 described with reference to FIG. 7. For example, the buffer pattern BFP may include the first buffer pattern BFP1 and the second buffer pattern BFP2, but embodiments are not limited thereto.

As the buffer pattern BFP is located, the height of the corresponding reflective electrode in the third direction DR3 may be adjusted. For example, the buffer pattern BFP may be located between the first reflective electrode RE1 and the via layer VIAL in the first sub-pixel SP1. The buffer pattern BFP is not located between the second reflective electrode RE2 and the via layer VIAL in the second sub-pixel SP3. The second reflective electrode RE2 may be directly located on the via layer VIAL. Likewise, in the third sub-pixel SP3, the buffer pattern BFP is not located between the third reflective electrode RE3 and the via layer VIAL. The third reflective electrode RE3 may be directly located on the via layer VIAL.

The first sub-pixel SP1 may have a resonant distance shorter than other sub-pixels due to the buffer pattern BFP. As such, the adjusted resonant distance may make it possible for light in a specific wavelength range (e.g., red color) to be efficiently amplified. Consequently, the first sub-pixel SP1 may effectively and efficiently output light in the corresponding wavelength range.

In FIG. 9, there is illustrated the case where the buffer pattern BFP is provided in the first sub-pixel SP1 but is not provided in the second and third sub-pixels SP2 and SP3, but embodiments are not limited thereto. The buffer pattern may also be provided in at least one of the second or third sub-pixels SP2 or SP3 so that the resonant distance of at least one of the second or third sub-pixels SP2 or SP3 can be adjusted. For example, the buffer pattern BFP may also be provided in the second sub-pixel SP2 so that the resonant distance of the second sub-pixel SP2 can be adjusted. For example, the distance between the second reflective electrode RE2 and the cathode electrode CE may be the same between the first reflective electrode RE1 and the cathode electrode CE. The distance between the third reflective electrode RE3 and the cathode electrode CE may be greater than the distance between the first reflective electrode RE1 and the cathode electrode CE.

The buffer pattern BFP of FIG. 9 may also be applied to the embodiments illustrated with respect to FIG. 7.

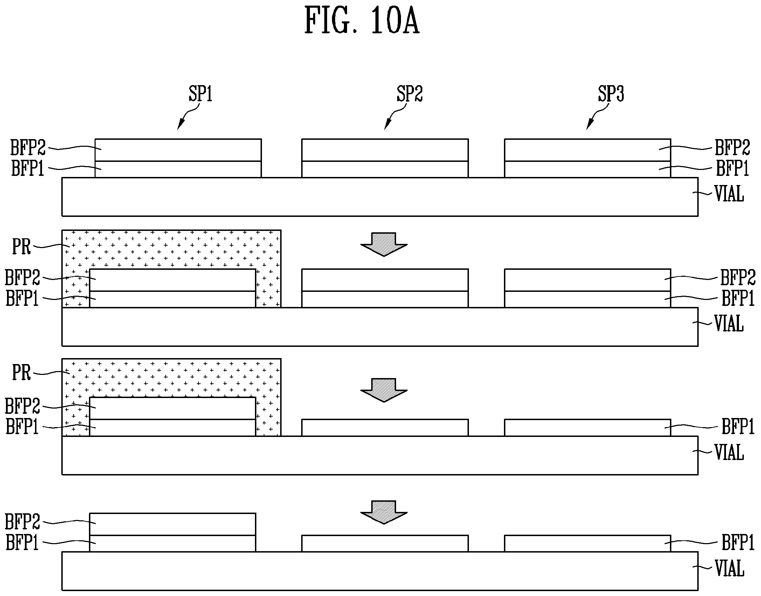

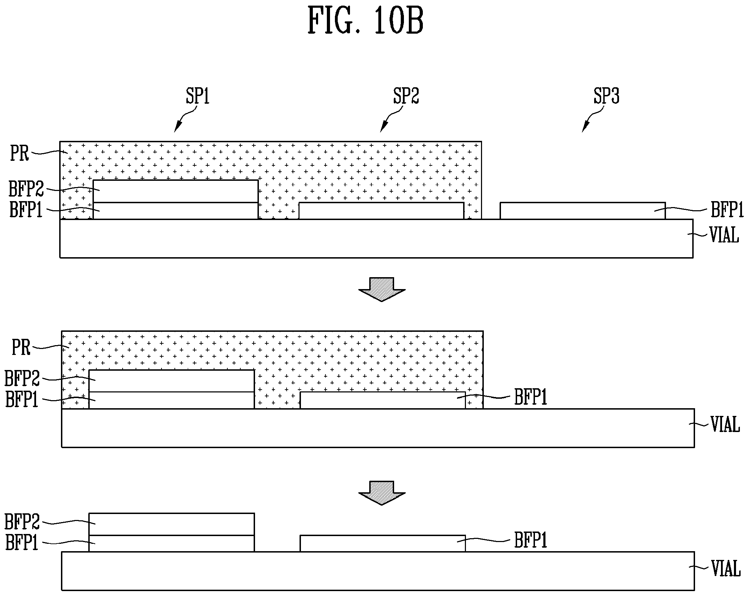

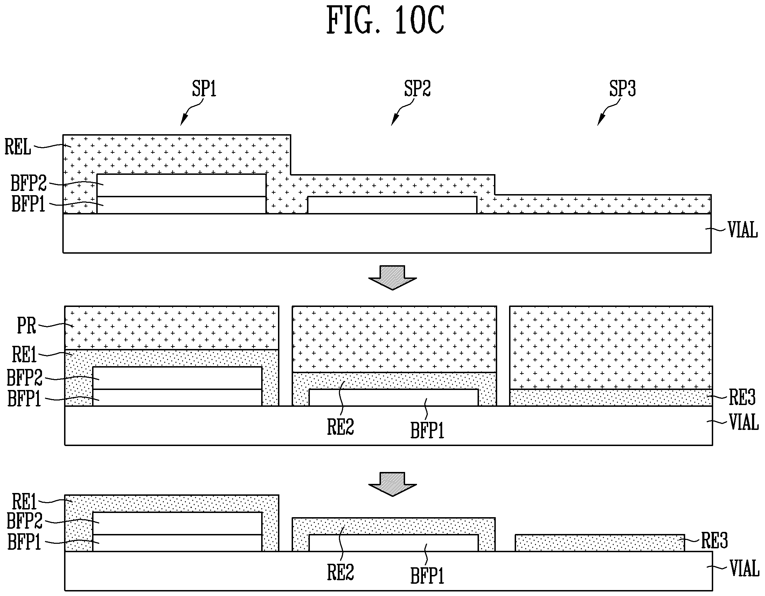

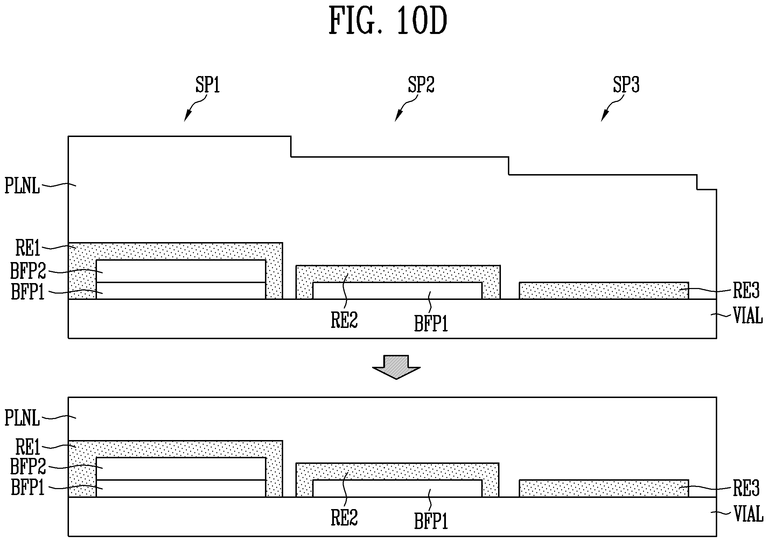

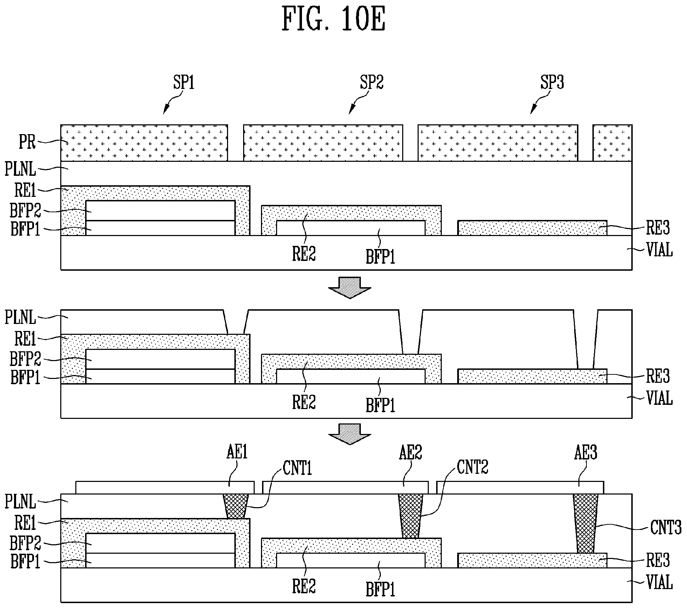

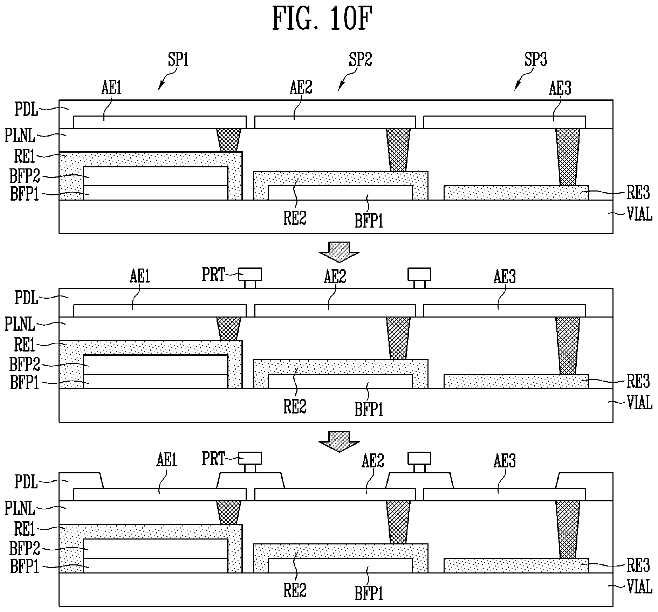

FIGS. 10A, 10B, 10C, 10D, 10E, and 10F are sectional views for describing a method of fabricating the display device in accordance with embodiments. The display device according to the embodiments of FIG. 7 may be fabricated by the display device fabrication method of FIGS. 10A to 10F. For the sake of convenience, some redundant explanations overlapping the embodiments of FIG. 7 may be omitted.

Referring to FIGS. 7 and 10A, the buffer pattern is formed in a first sub-pixel area (i.e., an area for the first sub-pixel SP1) of the via layer VIAL (or the base layer). Here, the buffer pattern may include the first buffer pattern BFP1 and the second buffer pattern BFP2.

According to some embodiments, the first buffer pattern BFP1 and the second buffer pattern BFP2 may be formed in each of first to third sub-pixel areas (i.e., areas for the first to third sub-pixels SP1 to SP3). The first buffer pattern BFP1 may be formed on the via layer VIAL. The second buffer pattern BFP2 may be formed on the first buffer pattern BFP1.

Thereafter, a photoresist layer PR may be formed in the first sub-pixel area. The photoresist layer PR may cover the first buffer pattern BFP1 and the second buffer pattern BFP2 in the first sub-pixel area.

Subsequently, the second buffer pattern BFP2 may be removed from the second and third sub-pixel areas. For example, the second buffer pattern BFP2 may be removed through an etching process. The first buffer pattern BFP1 includes material different from the material of the second buffer pattern BFP2. Hence, only the second buffer pattern BFP2 may be removed.

Thereafter, the photoresist layer PR may be removed. Consequently, the second buffer pattern BFP2 may be present only in the first sub-pixel area.

Referring to FIG. 10B, the first buffer pattern BFP1 in the third sub-pixel area is removed.

According to some embodiments, a photoresist layer PR may be formed in the first and second sub-pixel areas. The photoresist layer PR may cover the second buffer pattern BFP2 in the first sub-pixel area and the first buffer pattern BFP1 in the first sub-pixel area.

Subsequently, the first buffer pattern BFP1 in the third sub-pixel area may be removed. For example, the first buffer pattern BFP1 may be removed through an etching process.

Thereafter, the photoresist layer PR may be removed.

Through the process of FIGS. 10A and 10B, the first buffer pattern BFP1 and the second buffer pattern BFP2 are formed in the first sub-pixel area, only the first buffer pattern BFP1 is formed in the second sub-pixel area, and no buffer pattern is placed in the third sub-pixel area.

Referring to FIG. 10C, the reflective electrodes RE1 to RE3 may be respectively formed in the first to third sub-pixel areas.

According to some embodiments, a reflective electrode layer REL may be formed on an overall surface of the via layer VIAL. The reflective electrode layer REL may cover the via layer VIAL, the second buffer pattern BFP2 in the first sub-pixel area, and the first buffer pattern BFP1 in the second sub-pixel area.

Thereafter, a photoresist layer PR may be formed on the reflective electrode layer REL. The photoresist layer PR may be formed in each of the first to third sub-pixel areas, and may not be formed or may be removed in areas between the first to third sub-pixels SP1 to SP3 {or in the boundary areas BDA (refer to FIG. 7)}.

Thereafter, the first to third reflective electrodes RE1 to RE3 may be formed from the reflective electrode layer REL using the photoresist layer PR. For example, through an etching process using the photoresist layer PR as a mask, the reflective electrode layer REL is removed from the areas between the first to third sub-pixels SP1 to SP3 so that the first to third reflective electrodes RE1 to RE3 can be separated from each other.

Thereafter, the photoresist layer PR may be removed.

Referring to FIG. 10D, the planarization layer PLNL is formed to cover the reflective electrodes RE1 to RE3 and provide a planar upper surface.

According to some embodiments, the planarization layer PLNL may be formed on the overall surface of the via layer VIAL. The planarization layer PLNL may include inorganic material. The upper surface of the planarization layer PLNL may have a stepped portion due to a difference in height between the first to third reflective electrodes RE1 to RE3.

Thereafter, the upper surface of the planarization layer PLNL may be planarized through a planarization process. For example, the upper surface of the planarization layer PLNL may be planarized through a chemical mechanical polishing (CMP) process.

Referring to FIGS. 7, 10E, and 10F, the light emitting elements LD1 to LD3 may be formed on the planarization layer PLNL.

As illustrated in FIG. 10E, the anode electrodes AE1 to AE3 are formed on the planarization layer PLNL.

According to some embodiments, a photoresist layer PR may be formed on the planarization layer PLNL. Contact holes through which the reflective electrodes RE1 to RE3 are partially exposed may be formed in the planarization layer PLNL using the photoresist layer PR as a mask. After the contact holes are formed, the photoresist layer PR may be removed.

Thereafter, connection electrodes CNT1 to CNT3 may be formed in the respective contact holes of the sub-pixel area. The anode electrodes AE1 to AE3 may be formed on the planarization layer PLNL.

For example, the contact hole of the planarization layer PLNL in the first sub-pixel area may be filled with the first connection electrode CNT1. The contact hole of the planarization layer PLNL in the second sub-pixel area may be filled with the second connection electrode CNT2. The contact hole of the planarization layer PLNL in the third sub-pixel area may be filled with the third connection electrode CNT3. The connection electrodes CNT1 to CNT3 may include metal. For example, each connection electrode may include tungsten (W).

The first anode electrode AE1 may be located in the first sub-pixel area, and may be electrically connected to the first reflective electrode RE1 through the first connection electrode CNT1. The second anode electrode AE2 may be located in the second sub-pixel area, and may be electrically connected to the second reflective electrode RE2 through the second connection electrode CNT2. The third anode electrode AE3 may be located in the third sub-pixel area, and may be electrically connected to the third reflective electrode RE3 through the third connection electrode CNT3.

Although in FIG. 10E the connection electrodes CNT1 to CNT3 are illustrated as being located in the contact holes, embodiments are not limited thereto. For example, the anode electrodes AE1 to AE3 may be respectively connected to the reflective electrodes RE1 to RE3 without connection electrodes. In other words, the connection electrodes CNT1 to CNT3 may be omitted.

As illustrated in FIG. 10F, the pixel defining layer PDL may be formed on the planarization layer PLNL and the anode electrodes AE1 to AE3.

According to some embodiments, the pixel defining layer PDL may be formed on an overall surface of the planarization layer PLNL. The pixel defining layer PDL may cover the anode electrodes AE1 to AE3.

Thereafter, the protrusion pattern PRT may be formed on the pixel defining layer PDL. The protrusion pattern PRT may function as the separator SPR (refer to FIG. 7).

Subsequently, openings through which respective portions of the anode electrodes AE1 to AE3 are exposed may be formed in the pixel defining layer PDL.

Although the formation of the protrusion pattern PRT has been described with reference to FIG. 10F, embodiments are not limited thereto. For example, in lieu of the formation of the protrusion pattern PRT, the trenches TRCH1 and TRCH2 (refer to FIG. 8) may be formed in the pixel defining layer PDL.

Thereafter, the other components illustrated in FIG. 7, e.g., the emission structure EMS, the cathode electrode CE, and the encapsulation layer TFE, may be sequentially formed. As a result, the display device 10 according to the embodiments of FIG. 7 may be fabricated.

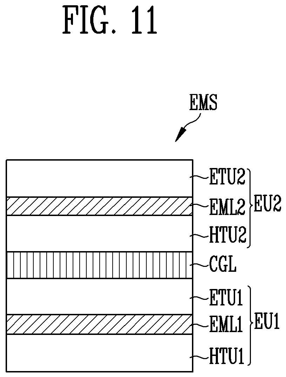

FIG. 11 is a sectional view illustrating aspects of the emission structure included in any one of the first to third light emitting elements LD1 to LD3 of FIG. 7.

Referring to FIG. 11, an emission structure EMS may have a tandem structure in which first and second emission components EU1 and EU2 are stacked. The emission structure EMS may have a substantially identical configuration in each of the first to third light emitting elements LD1 to LD3 of FIG. 7.

Each of the first and second emission components EU1 and EU2 may include at least one emission layer configured to generate light in response to current applied thereto. The first emission component EU1 may include a first emission layer EML1, a first electron transport component ETU1, and a first hole transport component HTU1. The first emission layer EML1 may be located between the first electron transport component ETU1 and the first hole transport component HTU1. The second emission component EU2 may include a second emission layer EML2, a second electron transport component ETU2, and a second hole transport component HTU2. The second emission layer EML2 may be located between the second electron transport component ETU2 and the second hole transport component HTU2.

Each of the first and second hole transport components HTU1 and HTU2 may include at least one of a hole injection layer or a hole transport layer, and may further include a hole buffer layer, an electron blocking layer, and the like, as needed. The first and second hole transport components HTU1 and HTU2 may have the same configuration or have different configurations.

Each of the first and second electron transport components ETU1 and ETU2 may include at least one of an electron injection layer or an electron transport layer, and may further include an electron buffer layer, a hole blocking layer, and the like, as needed. The first and second electron transport components ETU1 and ETU2 may have the same configuration or have different configurations.

A connection layer, which can be provided in the form of a charge generation layer CGL, may be located between the first emission component EU1 and the second emission component EU2 to connect the first and second emission components EU1 and EU2 to each other. According to some embodiments, the charge generation layer CGL may have a stacked structure including a p-dopant layer and an n-dopant layer. For example, the p-dopant layer may include a p-type dopant such as HAT-CN, TCNQ, or NDP-9, and the n-dopant layer may include alkali metal, alkaline earth metal, lanthanide metal, or a combination thereof. However, embodiments are not limited to the aforementioned example.

According to some embodiments, the first emission layer EML1 and the second emission layer EML2 may generate light in different colors. The light emitted from the first emission layer EML1 and the second emission layer EML2 may be mixed to be visible as white light. For instance, the first emission layer EML1 may generate blue light, and the second emission layer EML2 may generate yellow light. According to some embodiments, the second emission layer EML2 may include a stacked structure including a first sub-emission layer configured to generate red light, and a second sub-emission layer configured to generate green light. Red light and green light may be mixed to provide yellow light. In this case, an intermediate layer configured to perform functions of transporting holes and/or blocking the transport of electrons may be further located between the first and second sub-emission layers.

In other embodiments, the first emission layer EML1 and the second emission layer EML2 may generate light in the same color.

The emission structure EMS may be formed through a scheme such as vacuum deposition, inkjet printing, or the like, but embodiments are not limited thereto.

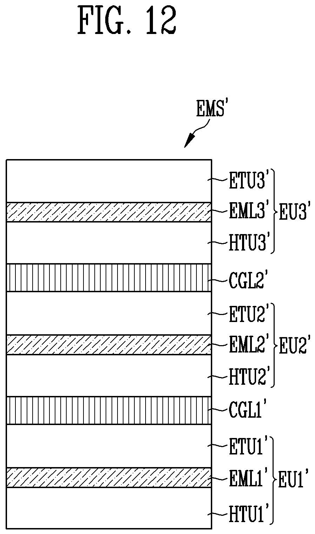

FIG. 12 is a sectional view illustrating further details of the emission structure included in any one of the first to third light emitting elements LD1 to LD3 of FIG. 7 according to some embodiments.

Referring to FIG. 12, an emission structure EMS' may have a tandem structure in which first to third emission components EU1' to EU3' are stacked. The emission structure EMS' may have a substantially identical configuration in each of the first to third light emitting elements LD1 to LD3 of FIG. 7.

Each of the first to third emission components EU1' to EU3' may include an emission layer configured to generate light in response to current applied thereto. The first emission component EU1' may include a first emission layer EML1', a first electron transport component ETU1', and a first hole transport component HTU1'. The first emission layer EML1' may be located between the first electron transport component ETU1' and the first hole transport component HTU1'. The second emission component EU2' may include a second emission layer EML2', a second electron transport component ETU2', and a second hole transport component HTU2'. The second emission layer EML2' may be located between the second electron transport component ETU2' and the second hole transport component HTU2'. The third emission component EU3' may include a third emission layer EML3', a third electron transport component ETU3', and a third hole transport component HTU3'. The third emission layer EML3' may be located between the third electron transport component ETU3' and the third hole transport component HTU3'.

Each of the first to third hole transport components HTU1' to HTU3' may include at least one of a hole injection layer or a hole transport layer, and may further include a hole buffer layer, an electron blocking layer, and the like, as needed. The first to third hole transport components HTU1' to HTU3' may have the same configuration or have different configurations.

Each of the first to third electron transport components ETU1' to ETU3' may include at least one of an electron injection layer or an electron transport layer, and may further include an electron buffer layer, a hole blocking layer, and the like, as needed. The first to third electron transport components ETU1' to ETU3' may have the same configuration or have different configurations.

A first charge generation layer CGL1' may be located between the first emission component EU1' and the second emission component EU2'. A second charge generation layer CGL2' may be located between the second emission component EU2' and the third emission component EU3'.

According to some embodiments, the first to third emission layers EML1' to EML3' may generate light in different colors. Light emitted from the first to third emission layers EML1' to EML3' may be mixed to be visible as white light. For example, the first emission layer EML'1 may generate blue light, the second emission layer EML2' may generate green light, and the third emission layer EML3' may generate red light.

According to some embodiments, two or more emission layers among the first to third emission layers EML1' to EML3' may generate light in the same color.

Unlike the case described with reference to FIGS. 11 and 12, the emission structure EMS of FIG. 7 may include one emission component in each of the first to third light emitting elements LD1 to LD3. Here, the respective emission components included in the first to third light emitting elements LD1 to LD3 may be configured to emit light in different colors. For example, the emission component of the first light emitting element LD1 may emit red light, the emission component of the second light emitting element LD2 may emit green light, and the emission component of the third light emitting element LD3 may emit blue light. In this case, unlike the case described with reference to FIG. 7, the emission components of the first to third sub-pixels SP1 to SP3 may be separated from each other, and each may be located in the corresponding opening OP of the pixel defining layer PDL. In this case, at least some of the color filters CF1 to CF3 may be omitted.

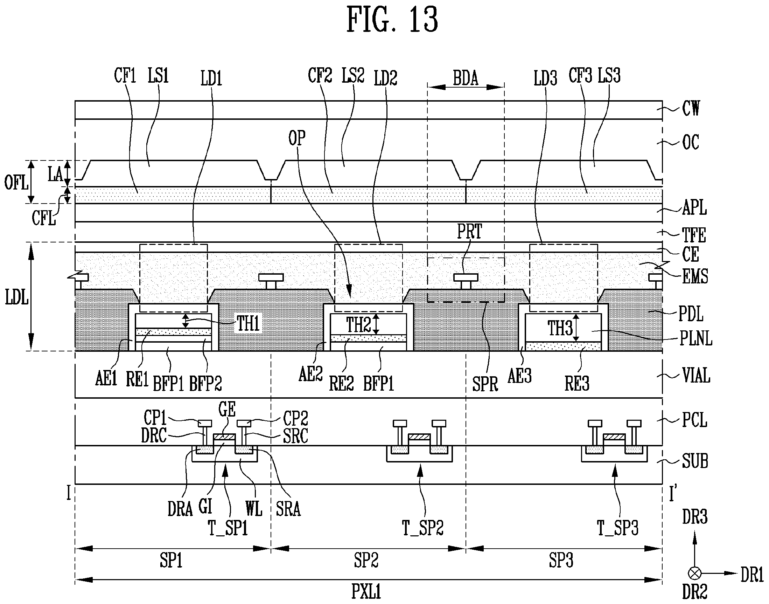

FIG. 13 is a sectional view illustrating further details of the pixel taken along the line I-I' of FIG. 6 according to some embodiments.

Referring to FIGS. 7 and 13, the embodiments depicted in FIG. 13 except anode electrode AE1 to AE3 may be substantially identical or similar to the embodiments depicted in FIG. 7. Therefore, some repetitive explanation thereof may be omitted.

According to some embodiments, the anode electrodes AE1 to AE3 may cover the reflective electrodes RE1 to RE3, and contact side surfaces of the reflective electrodes RE1 to RE3.

In the first sub-pixel SP1, the first anode electrode AE1 may cover the first buffer pattern BFP1, the second buffer pattern BFP2, the first reflective electrode RE1, and the planarization layer PLNL (or an insulating pattern), and may contact respective side surfaces of the first buffer pattern BFP1, the second buffer pattern BFP2, the first reflective electrode RE1, and the planarization layer PLNL.

Likewise, in the second sub-pixel SP2, the second anode electrode AE2 may cover the first buffer pattern BFP1, the second reflective electrode RE2, and the planarization layer PLNL, and may contact respective side surfaces of the first buffer pattern BFP1, the second reflective electrode RE2, and the planarization layer PLNL.

In the third sub-pixel SP3, the third anode electrode AE3 may cover the third reflective electrode RE3 and the planarization layer PLNL, and may contact respective side surfaces of the third reflective electrode RE3 and the planarization layer PLNL.

In this case, the contact holes (or the corresponding connection electrodes) of the planarization layer PLNL for connection between the anode electrodes AE1 to AE3 and the reflective electrodes RE1 to RE3 may be omitted. The size of the emission area of each of the first to third sub-pixels SP1 to SP3 (or an area from which amplified light is outputted) may increase.

The pixel defining layer PDL may be located on the planarization layer PLNL and some portions of the first to third anode electrodes AE1 to AE3. The pixel defining layer PDL may be directly located on the planarization layer PLNL.

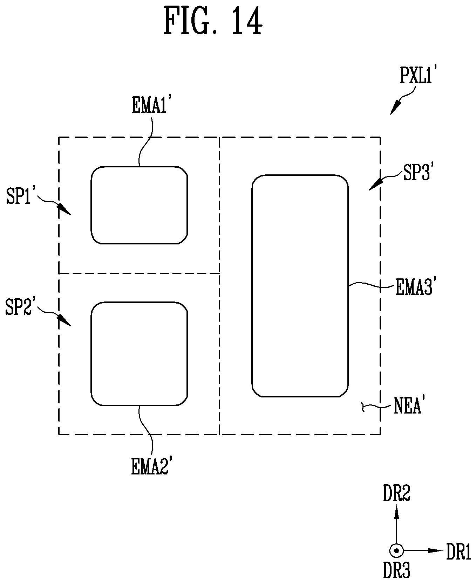

FIG. 14 is a plan view illustrating further details of the pixels of FIG. 5 according to some embodiments.

Referring to FIG. 14, a first pixel PXL1' may include first to third sub-pixels SP1' to SP3'.

The first sub-pixel SP1' may include a first emission area EMA1' and a non-emission area NEA' formed around the first emission area EMA1'. The second sub-pixel SP2' may include a second emission area EMA2' and a non-emission area NEA' formed around the second emission area EMA2'. The third sub-pixel SP3' may include a third emission area EMA3' and a non-emission area NEA' formed around the third emission area EMA3'.

The first sub-pixel SP1' and the second sub-pixel SP2' may be arranged in the second direction DR2. The third sub-pixel SP3' may be located in the first direction with respect to each of the first and second sub-pixels SP1' and SP2'.

The second sub-pixel SP2' may have a larger surface area than the first sub-pixel SP1'. The third sub-pixel SP3' may have a larger surface area than the second sub-pixel SP2'. Therefore, the second emission area EMA2' may have a larger surface area than the first emission area EMA1'. The third emission area EMA3' may have a larger surface area than the second emission area EMA2'. However, embodiments are not limited to the aforementioned example. For example, the first and second sub-pixels SP1' and SP2' may have substantially the same surface area. The third sub-pixel SP3' may have a larger surface area than each of the first and second sub-pixels SP1' and SP2'. As such, the surface areas of the first to third sub-pixels SP1' to SP3' may be changed in various ways depending on embodiments.

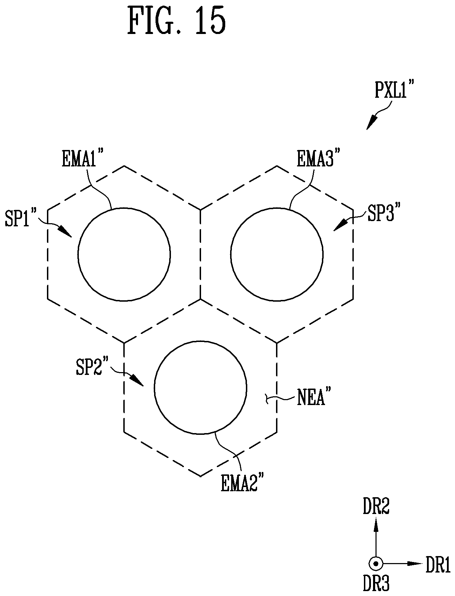

FIG. 15 is a plan view illustrating further details of the pixels of FIG. 5 according to some embodiments.

Referring to FIG. 15, a first sub-pixel SP1" may include a first emission area EMA1" and a non-emission area NEA" formed around the first emission area EMA1". A second sub-pixel SP2" may include a second emission area EMA2" and a non-emission area NEA" formed around the second emission area EMA2". The third sub-pixel SP3" may include a third emission area EMA3" and a non-emission area NEA" formed around the third emission area EMA3".

Each of the first to third sub-pixels SP1" to SP3" may have a polygonal shape in the third direction DR3. For example, the shapes of the first to third sub-pixels SP1" to SP3" may be hexagonal, as illustrated in FIG. 11.

Each of the first to third emission areas EMA1" to EMA3" may have a circular shape in the third direction DR3. However, embodiments are not limited to the aforementioned example. For example, each of the first to third emission areas EMA1" to EMA3" may have a polygonal shape.

The first and third sub-pixels SP1" and SP3" may be arranged in the first direction DR1. The second sub-pixel SP2" may be arranged in a direction (or a diagonal direction) inclined at an acute angle based on the second direction DR2 with respect to the first sub-pixel SP1".

The arrangements of the sub-pixels illustrated in FIGS. 6, 14, and 15 are illustrative, and embodiments are not limited thereto. Each pixel may include two or more sub-pixels, and the sub-pixels may be arranged in various ways. Each of the sub-pixels may have various shapes. Each of the emission areas of the sub-pixels may also have various shapes.

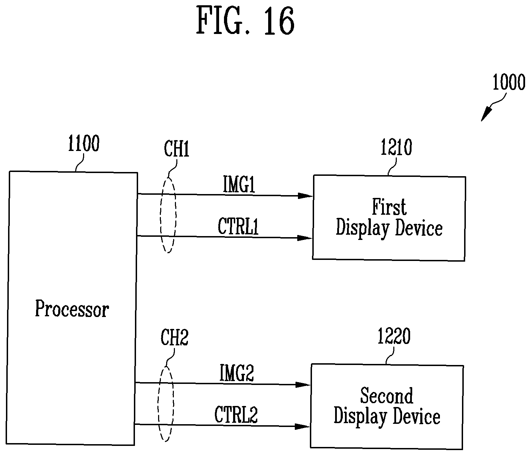

FIG. 16 is a block diagram illustrating aspects of a display system according to some embodiments.

Referring to FIG. 16, the display system 1000 may include a processor 1100, and one or more display devices 1210 and 1220.

The processor 1100 may perform various tasks and operations. According to some embodiments, the processor 1100 may include an application processor, a graphic processor, a microprocessor, a central processing unit (CPU), and so on. The processor 1100 may be connected to the other components of the display system 1000 through a bus system to control the components.

In FIG. 16, there is illustrated the case where the display system 1000 includes the first and second display devices 1210 and 1220. The processor 1100 may be connected to the first display device 1210 through a first channel CH1, and may be connected to the second display device 1220 through a second channel CH2.

The processor 1100 may transmit first image data IMG1 and a first control signal CTRL1 to the first display device 1210 through the first channel CH1. The first display device 1210 may display an image based on the first image data IMG1 and the first control signal CTRL1. The first display device 1210 may be configured in the same manner as the display device 100 described with reference to FIG. 1. In this case, the first image data IMG1 and the first control signal CTRL1 may be provided as the input image data IMG and the control signal CTRL of FIG. 1, respectively.

The processor 1100 may transmit second image data IMG2 and a second control signal CTRL2 to the second display device 1220 through the second channel CH2. The second display device 1220 may display an image based on the second image data IMG2 and the second control signal CTRL2. The first display device 1220 may be configured in the same manner as the display device 100 described with reference to FIG. 1. In this case, the second image data IMG2 and the second control signal CTRL2 may be provided as the input image data IMG and the control signal CTRL of FIG. 2, respectively.

The display system 1000 may include computing systems that provide an image display function, such as a portable computer, a mobile phone, a smart phone, a tablet personal computer (tablet PC), a smart watch, a watch phone, a portable multimedia player, a navigation system, and an ultra-mobile personal computer (UMPC). Furthermore, the display system 1000 may include at least one of a head-mounted display (HMD), a virtual reality (VR) device, a mixed reality (MR) device, or an augmented reality (AR) device.

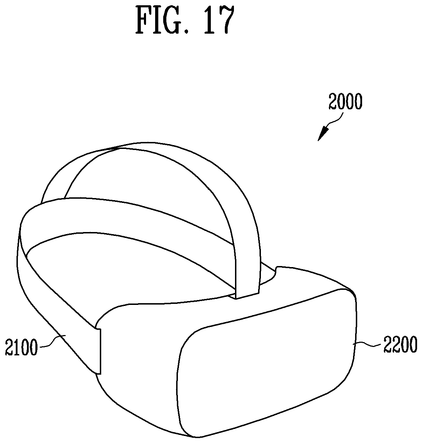

FIG. 17 is a perspective diagram illustrating an application example of the display system of FIG. 16.

Referring to FIG. 17, the display system 1000 of FIG. 16 may be applied to a head-mounted display device 2000. The head-mounted display device 2000 may be a wearable electronic device, which can be worn on the head of the user.

The head-mounted display device 2000 may include a head-mounted band 2100 and a display device reception casing 2200. The head-mounted band 2100 may be connected to the display device reception casing 2200. The head-mounted band 2100 may include a horizontal band and/or a vertical band to fasten the head-mounted display device 2000 to the head of the user. The horizontal band may enclose the sides of the head of the user, and the vertical band may enclose the top of the head of the user. However, embodiments are not limited to the aforementioned example. For example, the head-mounted band 2100 may be implemented in the form of eyeglass frames, a helmet, and so on.

The display device reception casing 2200 may receive the first and second display devices 1210 and 1220 of FIG. 12. The display device reception casing 2200 may further receive the processor 1100 of FIG. 12.

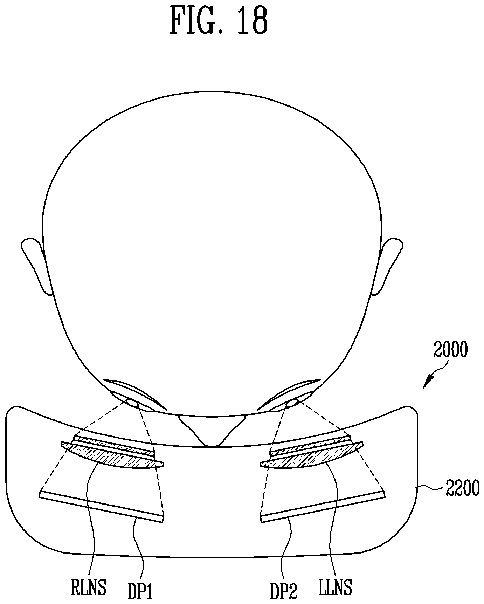

FIG. 18 is a diagram illustrating a head-mounted display device of FIG. 17 that is worn on a user.

Referring to FIG. 18, the head-mounted display device 2000 (or the wearable electronic device) may include a display panel configured to emit light, and a lens component located on the display panel (or on a light emission path). The display panel may include a first display panel DP1 of the first display device 1210, and a second display panel DP2 of the second display device 1220. The lens component may further include one or more lenses LLNS and RLNS.

In the display device reception casing 2200, the right-eye lens RLNS may be positioned between the first display panel DP1 and the right eye of the user. In the display device reception casing 2200, the left-eye lens LLNS may be positioned between the second display panel DP2 and the left eye of the user.

An image outputted from the first display panel DP1 can be viewed by the right eye of the user through the right-eye lens RLNS. The right lens RLNS may refract light emitted from the first display panel DP1 toward the right eye of the user. The right-eye lens RLNS may perform an optical function to adjust a viewing distance between the first display panel DP1 and the right eye of the user.

An image outputted from the second display panel DP2 can be viewed by the left eye of the user through the left-eye lens LLNS. The left lens LLNS may refract light emitted from the second display panel DP2 toward the left eye of the user. The left-eye lens LLNS may perform an optical function to adjust a viewing distance between the second display panel DP2 and the left eye of the user.

According to some embodiments, each of the right-eye lens RLNS and the left-eye lens LLNS may include an optical lens having a pancake-shaped cross-section. According to some embodiments, each of the right-eye lens RLNS and the left-eye lens LLNS may include a multi-channel lens including sub-areas having different optical characteristics. In this case, each display panel may output images respectively corresponding to sub-areas of the multi-channel lens. The output images may be viewed to the user through the corresponding sub-areas.

In a display device and a wearable electronic device in accordance with embodiments of the present disclosure, a buffer pattern may be located under reflective electrodes of some sub-pixels. In this case, the corresponding sub-pixel may have a resonant distance shorter than other sub-pixels. The adjusted resonant distance may make it possible for light in a specific wavelength range (e.g., red color) to be effectively and efficiently amplified. Consequently, the sub-pixel may effectively and relatively efficiently output light in the corresponding wavelength range.

In a method of fabricating the display device in accordance with embodiments of the present disclosure, the buffer pattern may be formed under the reflective electrode of only some of the sub-pixels.

The characteristics of embodiments according to the present disclosure are not limited by the foregoing, and other various other characteristics are included herein.

Although aspects of some embodiments and implementations have been described herein, other embodiments and modifications will be apparent from the foregoing description. Accordingly, the concepts of embodiments according to the present disclosure are not limited to the foregoing embodiments, but rather are defined by the broader scope of the presented claims and various obvious modifications and equivalent arrangements.

## Claims

1. A display device, comprising:
a first sub-pixel, a second sub-pixel, and a third sub-pixel,
wherein each of the first sub-pixel, the second sub-pixel, and the third sub-pixel comprises:
a reflective electrode on a base layer;
a planarization layer on the reflective electrode and providing a planar upper surface;
an anode electrode on the planarization layer;
an emission structure on the anode electrode; and
a cathode electrode on the emission structure,
wherein the first sub-pixel further includes a first buffer pattern between the base layer and the reflective electrode, and
wherein in the third sub-pixel, the reflective electrode is directly on the base layer.

2. The display device according to claim 1, wherein an average distance between the anode electrode and the reflective electrode in the first sub-pixel is less than an average distance between the anode electrode and the reflective electrode in the third sub-pixel.

3. The display device according to claim 1 or claim 2,
wherein the first sub-pixel further includes a second buffer pattern between the first buffer pattern and the reflective electrode,
wherein the second sub-pixel further includes the first buffer pattern between the base layer and the reflective electrode, and
wherein an average distance between the anode electrode and the reflective electrode in the second sub-pixel is less than an average distance between the anode electrode and the reflective electrode in the third sub-pixel and greater than an average distance between the anode electrode and the reflective electrode in the first sub-pixel.

4. The display device according to claim 3, wherein a thickness of the anode electrode in the first sub-pixel, a thickness of the anode electrode in the second sub-pixel, and a thickness of the anode electrode in the third sub-pixel are equal to each other.

5. The display device according to claim 3 or claim 4,
wherein:
(i) the first buffer pattern includes conductive material, and
wherein the second buffer pattern includes insulating material; and/or
(ii) a thickness of the first buffer pattern is equal to a thickness of the second buffer pattern.

6. The display device according to any one of claims 3 to 5,
wherein an average thickness of the planarization layer in the second sub-pixel is in a range of 1.4 times to 1.7 times an average thickness of the planarization layer in the first sub-pixel, and
wherein an average thickness of the planarization layer in the third sub-pixel is in a range of 1.9 times to 2.4 times an average thickness of the planarization layer in the first sub-pixel.

7. The display device according to any one of claims 1 to 6, wherein the emission structure comprises:
a first emission layer arranged in common in the first sub-pixel, the second sub-pixel, and the third sub-pixels, and configured to emit light in a first color; and
a second emission layer on the first emission layer and configured to emit light in a second color, optionally wherein the emission structure further includes a third emission layer on the second emission layer and configured to emit light in a third color.

8. The display device according to claim 1 or claim 2, wherein in the second sub-pixel, the reflective electrode is directly on the base layer.

9. The display device according to any one of claims 1 to 8, wherein the anode electrode covers the reflective electrode and contacts a side surface of the reflective electrode.

10. The display device according to any one of claims 1 to 9, wherein:
(i) the display device further comprises:
a pixel defining layer on the base layer between the first to the third sub-pixels; and
a protrusion pattern on the pixel defining layer and having a width increasing in an upward direction; and/or
(ii) trenches are formed to partially penetrate the planarization layer between the first to the third sub-pixels, and
wherein the trenches are separated from each other.

11. The display device according to any one of claims 1 to 10, wherein each of the first to the third sub-pixels further comprises a color filter on the cathode electrode.

12. A wearable electronic device comprising:
a display panel configured to emit light; and
at least one lens on the display panel,
wherein the display panel includes a first sub-pixel, a second sub-pixel, and a third sub-pixel,
wherein each of the first sub-pixel, the second sub-pixel, and the third sub-pixel comprises:
a reflective electrode on a base layer;
a planarization layer on the reflective electrode and configured to provide a planar upper surface;
an anode electrode on the planarization layer;
an emission structure on the anode electrode; and
a cathode electrode on the emission structure,
wherein the first sub-pixel further includes a first buffer pattern between the base layer and the reflective electrode, and
wherein in the third sub-pixel, the reflective electrode is directly on the base layer.

13. The wearable electronic device according to claim 12, wherein:
(i) an average distance between the anode electrode and the reflective electrode in the first sub-pixel is less than an average distance between the anode electrode and the reflective electrode in the third sub-pixel; and/or
(ii) the first sub-pixel further includes a second buffer pattern between the first buffer pattern and the reflective electrode,
wherein the second sub-pixel further includes the first buffer pattern between the base layer and the reflective electrode, and
wherein an average distance between the anode electrode and the reflective electrode in the second sub-pixel is less than an average distance between the anode electrode and the reflective electrode in the third sub-pixel and greater than an average distance between the anode electrode and the reflective electrode in the first sub-pixel.

14. A method of fabricating a display device, comprising:
forming a buffer pattern in first sub-pixel area on a base layer;
forming a reflective electrode over the buffer pattern of the first sub-pixel area and in a second sub-pixel area and a third sub-pixel area of the base layer;
forming a planarization layer to cover the reflective electrode and provide a planar upper surface; and
forming a light emitting element on the planarization layer,
wherein in the third sub-pixel area, the reflective electrode is directly on the base layer.

15. The method according to claim 14, wherein forming the buffer pattern comprises:
forming a first buffer pattern in each of the first to third sub-pixel areas, and a second buffer pattern on the first buffer pattern;
forming a photoresist layer in the first sub-pixel area, and removing the second buffer pattern from the second and the third sub-pixel areas; and
forming a photoresist layer in the first and the second sub-pixel areas, and removing the first buffer pattern from the third sub-pixel area,
wherein the buffer pattern of the first sub-pixel area includes the first buffer pattern and the second buffer pattern, optionally wherein the first buffer pattern includes conductive material, and the second buffer pattern includes insulating material.
